# EUROPÄISCHE PATENTSCHRIFT

(11) **EP 4 070 512 B1**
(45) Veröffentlichungstag und Bekanntmachung des Hinweises auf die Patenterteilung: **03.04.2024**
(21) Anmeldenummer: 20817306.2
(22) Anmeldetag: 01.12.2020
(51) Int. Cl.: H04L 12/403, H04L 12/40, H03M 13/09, H04L 1/00, H03M 13/35, H03M 13/00

(54) **TEILNEHMERSTATION FÜR EIN SERIELLES BUSSYSTEM UND VERFAHREN ZUR KOMMUNIKATION IN EINEM SERIELLEN BUSSYSTEM**
SUBSCRIBER STATION FOR A SERIAL BUS SYSTEM AND METHOD FOR COMMUNICATION IN A SERIAL BUS SYSTEM
STATION D'ABONNÉ POUR UN SYSTÈME DE BUS SÉRIE ET PROCÉDÉ DE COMMUNICATION DANS UN SYSTÈME DE BUS SÉRIE

(30) Priorität: 02.12.2019 DE 102019218714
(43) Veröffentlichungstag der Anmeldung: 12.10.2022
(73) Patentinhaber: Robert Bosch GmbH, 70442 Stuttgart (DE)
(72) Erfinder: HARTWICH, Florian, 72762 Reutlingen (DE); BAILER, Franz, 72116 Moessingen (DE); MUTTER, Arthur, 73765 Neuhausen (DE)
(86) Internationale Anmeldenummer: PCT/EP2020/084129
(87) Internationale Veröffentlichungsnummer: WO 2021/110678

(56) Entgegenhaltungen:
- WO-A1-2020/126760
- WO-A1-2020/157086
- DE-A1-102011 080 476
- DE-A1-102011 122 801

## Beschreibung

### Technisches Gebiet

Die vorliegende Erfindung betrifft eine Teilnehmerstation für ein serielles Bussystem und ein Verfahren zur Kommunikation in einem seriellen Bussystem, das mit hoher Datenrate sowie großer Flexibilität und großer Fehlerrobustheit arbeitet.

### Stand der Technik

Bussysteme für die Kommunikation zwischen Sensoren und Steuergeräten, beispielsweise in Fahrzeugen, sollen je nach der Anzahl an Funktionen einer technischen Anlage bzw. eines Fahrzeugs, die Übertragung einer großen Datenmenge ermöglichen. Dabei wird oft gefordert, dass die Daten schneller vom Sender zum Empfänger zu übertragen sind als bisher und bei Bedarf auch große Datenpakete übertragbar sind.

Bei Fahrzeugen ist derzeit ein Bussystem in der Einführungsphase, in welchem Daten als Nachrichten im Standard ISO11898-1:2015 als CAN Protokoll-Spezifikation mit CAN FD übertragen werden. Die Nachrichten werden zwischen den Busteilnehmern des Bussystems, wie Sensor, Steuergerät, Geber, usw., übertragen. CAN FD wird von den meisten Herstellern im ersten Schritt mit 2Mbit/s Datenbitrate und 500kbit/s Arbitrationsbitrate im Fahrzeug eingesetzt.

Um noch größere Datenraten zu ermöglichen, wird derzeit ein Nachfolgebussystem für CAN FD entwickelt, das nachfolgend CAN XL genannt wird. CAN XL soll neben dem reinen Datentransport über den CAN-Bus auch andere Funktionen unterstützen, wie funktionale Sicherheit (Safety), Datensicherheit (Security) und Dienstgüte (QoS = Quality of Service). Dies sind elementare Eigenschaften, die in einem autonom fahrenden Fahrzeug benötigt werden.

Sehr vorteilhaft ist, wenn CAN XL und CAN FD sowie Classical CAN kompatibel sind. In einem solchen Fall wird mit Hilfe des res-Bit im CAN FD Rahmen zwischen CAN FD und CAN XL Rahmen unterschieden. Aufgrund der Kompatibilität sind bis zu diesem res-Bit auch bei CAN XL die Regeln zu dynamischen Stuff-Bits anzuwenden, die für das CAN FD Arbitrationsfeld verwendet werden.

Für die funktionale Sicherheit eines Systems ist es sehr vorteilhaft und wichtig, dass die Restfehlerwahrscheinlichkeit möglichst gering ist. Eine Klasse 1 von Fehlern, nämlich fälschlicherweise invertiert abgetastete Bits (Bit Flips), und/oder eine Klasse 2 von Fehlern, nämlich lokal gehäufte Bitfehler (Burst Fehler), können mit Hilfe einer Prüfsumme (CRC = Cyclic Redundancy Check) mit ausreichender Wahrscheinlichkeit erkannt werden. Es soll angemerkt werden, dass eine empfangende Teilnehmerstation auch eine Formatprüfung des Rahmens vornimmt. Dies hilft, insbesondere auch Burstfehler zu erkennen. Die Güte der Fehlererkennung lässt sich über die Restfehlerwahrscheinlichkeit ausdrücken. Die Restfehlerwahrscheinlichkeit gibt an, wie wahrscheinlich es ist, dass ein Rahmen trotz Fehlers bei einer empfangenden Teilnehmerstation (Empfangsknoten) des Bussystems, die kein Sender des Rahmens ist, als korrekt akzeptiert wird.

Bei Classical CAN hat die CRC-Berechnung folgenden Nachteil. Bei Classical CAN gehen die dynamischen Stuff-Bits nicht in die CRC-Berechnung ein. Aus diesem Grund gibt es bei Classical CAN eine Klasse 3 von Fehlern, welche die Prüfsumme (CRC) nicht sicher erkennen kann. Dieser Fehler (Klasse 3) wird durch das Umkippen von nur zwei Bits verursacht, was auch als Bit Flip bezeichnet wird. Hierbei erzeugt der eine Bit Flip eine dynamische Stuff-Bedingung und der andere Bit Flip hebt eine dynamische Stuff-Bedingung auf. Dabei ist die Reihenfolge der Bit Flips in den seriell übertragenen Bits (Bitstrom) egal. Somit erkennt die CRC-Berechnung einen derartigen Fehler mit großer Wahrscheinlichkeit nicht, auch wenn die CRC-Berechnung eigentlich bei Classical CAN fünf Bit Flips (Fehler der Klasse 1) sicher erkennen kann. Somit ist ein Fehler der Klasse 3 ein besonders problematischer Fall oder ein kritischer Fehler.

DE 10 2011 080 476 A1 beschreibt ein Verfahren und eine Vorrichtung zur seriellen Datenübertragung zwischen wenigstens zwei Teilnehmern in einem seriellen Bussystem. Hier ist in Bezug auf CAN FD ein spezielles Verfahren zur CRC-Berechnung beschrieben.

Bei CAN FD hat die CRC-Berechnung jedoch folgenden Nachteil. Um bei CAN FD robust zu sein gegen den Fehler der Klasse 3, werden bei CAN FD die dynamischen Stuff-Bits in die CRC Berechnung einbezogen. Es hat sich jedoch später herausgestellt, dass es hier einen Fehler der Klasse 4 gibt, der von der CAN FD CRC nicht erkannt wird. Dieser Fehler der Klasse 4 ist ein einzelner Bitverlust (Bit Drop) oder eine Biteinfügung (Bit Insertion) in den Datenstrom der empfangenden Teilnehmerstation bei einer dynamischen Stuff-Bedingung. Das heißt wegen einer falschen Re-Synchronisation sieht die empfangende Teilnehmerstation ein Bit mehr oder ein Bit weniger als tatsächlich von der sendenden Teilnehmerstation (Sendeknoten) übertragen wird. Dies fällt aber nicht auf, weil die dynamischen Stuff-Bits bei CAN nur nach 5 gleichen Bits mit dem gleichem Wert eingefügt werden.

Die Einbeziehung der dynamischen Stuff-Bits in die CRC Berechnung bei CAN FD machen einen "Stuff-Bit-Zähler" im CRC Feld notwendig. Dieser "Stuff-Bit-Zähler" reduziert die Wahrscheinlichkeit, dass ein Fehler der Klasse 4 unentdeckt bleibt, löst das Problem aber nicht ganz. Ein solcher "Stuff-Bit-Zähler" führt jedoch zu Komplexität und Datenüberhang (Overhead), der die übertragbare Nutzdatenrate herabsetzt.

Außerdem gibt es bei CAN FD keine Kopfprüfsumme (Header CRC). Dadurch ist ein Fehler im Code des Datenlängefelds (DLC = DataLengthCode) nicht zu erkennen.

Somit kann ein Bitfehler im Code des Datenlängefelds dazu führen, dass eine empfangende Teilnehmerstation (Empfangsknoten) des Bussystems, die kein Sender des CAN FD-Rahmens ist, in dem CAN FD-Rahmen eine falsche Rahmenlänge dekodiert. Daher prüft die empfangende Teilnehmerstation (Empfangsknoten) die Prüfsumme (CRC) an der falschen Stelle.

Würde die CRC Berechnung bei CAN XL so durchgeführt wie bei CAN FD, dann hätte CAN XL die gleichen Nachteile wie CAN FD.

DE 10 2011 080 476 A1 beschreibt zumindest keine Kommunikationssteuereinrichtung, die in einen Rahmen zwei Prüfsummen einfügt, die unterschiedliche Bits des Rahmens einberechnen, und die in maximal eine der zwei Prüfsummen die dynamischen Stuff-Bits mit einberechnet. Zudem sind kein erstes Feld und kein zweites Feld offenbart, wie in Anspruch 1 beschrieben.

### Offenbarung der Erfindung

Daher ist es Aufgabe der vorliegenden Erfindung, eine Teilnehmerstation für ein serielles Bussystem und ein Verfahren zur Kommunikation in einem seriellen Bussystem bereitzustellen, welche die zuvor genannten Probleme lösen. Insbesondere sollen eine Teilnehmerstation für ein serielles Bussystem und ein Verfahren zur Kommunikation in einem seriellen Bussystem bereitgestellt werden, bei welchen Fehler im Zusammenhang mit dynamischen Stuff-Bits in einem Bitstrom, mit großer Sicherheit erkannt werden, um auch bei hoher Datenrate und einer Steigerung der Menge der Nutzdaten pro Rahmen eine große Fehlerrobustheit der Kommunikation zu realisieren.

Die Aufgabe wird durch eine Teilnehmerstation für ein serielles Bussystem mit den Merkmalen von Anspruch 1 gelöst. Die Teilnehmerstation hat eine Kommunikationssteuereinrichtung zum Steuern einer Kommunikation der Teilnehmerstation mit mindestens einer anderen Teilnehmerstation des Bussystems, und einer Sende-/Empfangseinrichtung, die zum seriellen Senden eines von der Kommunikationssteuereinrichtung erzeugten Sendesignals auf einen Bus des Bussystems ausgestaltet ist, und die zum seriellen Empfangen von Signalen von dem Bus des Bussystems ausgestaltet ist, wobei die Kommunikationssteuereinrichtung ausgestaltet ist, das Sendesignal gemäß einem Rahmen zu erzeugen und in dem Rahmen zwei Prüfsummen einzufügen, die unterschiedliche Bits des Rahmens einberechnen, wobei die Kommunikationssteuereinrichtung ausgestaltet ist, in den Rahmen dynamische Stuff-Bits derart einzufügen, dass nach 5 gleichen Bits in Folge ein inverses Stuff-Bit in den Bitstrom des Rahmens eingefügt wird, und wobei die Kommunikationssteuereinrichtung ausgestaltet ist, die zwei Prüfsummen derart zu berechnen, dass maximal eine der zwei Prüfsummen die dynamischen Stuff-Bits mit einberechnet, wie in Anspruch 1 beschrieben.

Die beschriebene Teilnehmerstation kann durch ihre Ausgestaltung Fehler der Klasse 3 und der Klasse 4 ausreichend sicher erkennen. Der Grund dafür ist, dass eine der beiden Prüfsummen (CRCs) im CAN XL Rahmen die Fehler der Klasse 3 ausreichend sicher erkennen kann und die andere Prüfsumme (CRC) die Fehler der Klasse 4 ausreichend sicher erkennen kann. Folglich kann ein "Stuff-Bit-Zähler" Feld im Rahmen eingespart werden, was die Nutzdatenrate erhöht. Demzufolge wird bei der zuvor beschriebenen Teilnehmerstation beispielsweise ein "Stuff Bit Count" Feld wie bei CAN FD nicht zwingend benötigt. Um die Restfehlerwahrscheinlichkeit noch weiter zu senken, kann beim CAN XL Rahmen trotzdem zusätzlich ein "Stuff Bit Count" Feld eingefügt werden, welches hier SBC Feld genannt wird.

Noch dazu kann die beschriebene Teilnehmerstation durch ihre Ausgestaltung die beiden genannten Nachteile von CAN FD im Zusammenhang mit Stuff-Bits sehr gut vermeiden. Das heißt, die Teilnehmerstation kann einen Fehler bei der Abtastung des Datenlängecodes ausreichend sicher erkennen. Dadurch kennt der Empfänger des Rahmens die richtige Rahmenlänge und kann daher auch die Prüfsumme (CRC = Cyclic Redundancy Check) am Ende des Rahmens an der richtigen Stelle prüfen.

Infolgedessen kann mit der Teilnehmerstation auch bei Steigerung der Menge der Nutzdaten pro Rahmen ein Senden und Empfangen der Rahmen mit großer funktionaler Sicherheit bei großer Flexibilität im Hinblick auf aktuelle Ereignisse im Betrieb des Bussystems und mit geringer Fehlerquote gewährleistet werden.

Hierbei ist es mit der Teilnehmerstation in dem Bussystem insbesondere möglich, in einer ersten Kommunikationsphase eine von CAN bekannte Arbitration beizubehalten und dennoch die Übertragungsrate gegenüber CAN oder CAN FD nochmals beträchtlich zu steigern.

Das von der Teilnehmerstation durchgeführte Verfahren kann auch zum Einsatz kommen, wenn in dem Bussystem auch mindestens eine CAN-Teilnehmerstation und/oder mindestens eine CAN FD Teilnehmerstation vorhanden ist, die Nachrichten nach dem CAN-Protokoll und/oder CAN FD Protokoll senden.

Vorteilhafte weitere Ausgestaltungen der Teilnehmerstation sind in den abhängigen Ansprüchen angegeben.

Die Kommunikationssteuereinrichtung ist ausgestaltet, ein erstes Feld in den Rahmen einzufügen, in dem die Anzahl der dynamischen Stuff-Bits codiert ist, wobei die Kommunikationssteuereinrichtung ausgestaltet ist, das mindestens eine erste Feld vor einem Datenfeld einzufügen, in dem Nutzdaten des Rahmens eingefügt sind.

Möglicherweise ist die Sende-/Empfangseinrichtung zum seriellen Senden eines von der Kommunikationssteuereinrichtung erzeugten Sendesignals auf einen Bus des Bussystems derart ausgestaltet, dass sich für eine Nachricht, die zwischen Teilnehmerstationen des Bussystems ausgetauscht wird, die Bitzeit eines in einer ersten Kommunikationsphase auf den Bus gesendeten Signals unterscheiden kann von einer Bitzeit eines in einer zweiten Kommunikationsphase gesendeten Signals.

Die Kommunikationssteuereinrichtung ist zudem ausgestaltet, ein zweites Feld in den Rahmen einzufügen, das zum Prüfen ausgestaltet ist, ob der Bitstrom des Rahmens in einer Teilnehmerstation des Bussystems, die den Rahmen empfängt jedoch nicht gesendet hat, um mindestens ein Bit im Vergleich zu dem erwarteten Rahmen versetzt ist, wobei die Kommunikationssteuereinrichtung ausgestaltet sein kann, das mindestens eine zweite Feld nach dem Datenfeld in dem Rahmen einzufügen, und nach einer Rahmenprüfsumme einzufügen, die über alle Bits in dem Rahmen gebildet wurde.

Gemäß einem Ausführungsbeispiel ist die Kommunikationssteuereinrichtung ausgestaltet, nach dem mindestens einen zweiten Feld ein Synchronisationsfeld mit zwei Bits in den Rahmen derart einzufügen, dass die zwei Bits unterschiedliche Werte haben, so dass die Bits eine Synchronisationsflanke bilden, die nach einem Bitmuster zum Umschalten der Bitrate zum Senden des Sendesignals auf den Bus und zum Umschalten eines Physical Layers der Sende-/Empfangseinrichtung angeordnet ist.

Möglich ist, dass der für die Nachricht gebildete Rahmen kompatibel zu CAN FD aufgebaut ist, wobei in einer ersten Kommunikationsphase ausgehandelt wird, welche der Teilnehmerstationen des Bussystems in einer nachfolgenden zweiten Kommunikationsphase einen zumindest zeitweise exklusiven, kollisionsfreien Zugriff auf den Bus bekommt.

Die zuvor beschriebene Teilnehmerstation kann Teil eines Bussystems sein, das zudem einen Bus und mindestens zwei Teilnehmerstationen umfasst, welche über den Bus derart miteinander verbunden sind, dass sie seriell miteinander kommunizieren können. Hierbei ist mindestens eine der mindestens zwei Teilnehmerstationen eine zuvor beschriebene Teilnehmerstation.

Die zuvor genannte Aufgabe wird zudem durch ein Verfahren zur Kommunikation in einem seriellen Bussystem nach Anspruch 8 gelöst. Das Verfahren wird mit einer Teilnehmerstation des Bussystems ausgeführt, die eine Kommunikationssteuereinrichtung und eine Sende-/Empfangseinrichtung aufweist,
wobei das Verfahren die Schritte aufweist Steuern, mit der Kommunikationssteuereinrichtung einer Kommunikation der Teilnehmerstation mit mindestens einer anderen Teilnehmerstation des Bussystems, und Senden, mit der Sende-/Empfangseinrichtung, eines von der Kommunikationssteuereinrichtung erzeugten Sendesignals auf einen Bus des Bussystems, wobei die Sende-/Empfangseinrichtung zudem zum seriellen Empfangen von Signalen von dem Bus des Bussystems ausgestaltet ist, Erzeugen, mit der Kommunikationssteuereinrichtung, des Sendesignals gemäß einem Rahmen, wobei die Kommunikationssteuereinrichtung in den Rahmen zwei Prüfsummen einfügt, die unterschiedliche Bits des Rahmens einberechnen,
wobei die Kommunikationssteuereinrichtung in den Rahmen dynamische Stuff-Bits derart einfügt, dass nach 5 gleichen Bits in Folge ein inverses Stuff-Bit in den Bitstrom des Rahmens eingefügt wird, und wobei die Kommunikationssteuereinrichtung die zwei Prüfsummen derart berechnet, dass maximal eine der zwei Prüfsummen die dynamischen Stuff-Bits mit einberechnet, wie in Anspruch 8 beschrieben.

Das Verfahren bietet dieselben Vorteile, wie sie zuvor in Bezug auf die Teilnehmerstation genannt sind.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

### Zeichnungen

Nachfolgend ist die Erfindung unter Bezugnahme auf die beiliegende Zeichnung und anhand von Ausführungsbeispielen näher beschrieben. Es zeigen:
Fig. 1 ein vereinfachtes Blockschaltbild eines Bussystems gemäß einem ersten Ausführungsbeispiel;
Fig. 2 ein Schaubild zur Veranschaulichung des Aufbaus einer Nachricht, die von einer Teilnehmerstation des Bussystems gemäß dem ersten Ausführungsbeispiel gesendet werden kann;
Fig. 3 ein vereinfachtes schematisches Blockschaltbild einer Teilnehmerstation des Bussystems gemäß dem ersten Ausführungsbeispiel;
Fig. 4 einen zeitlichen Verlauf von Bussignalen CAN-XL_H und CAN-XL_L bei der Teilnehmerstation gemäß dem ersten Ausführungsbeispiel;
Fig. 5 einen zeitlichen Verlauf einer Differenzspannung VDIFF der Bussignale CAN-XL_H und CAN-XL_L bei der Teilnehmerstation gemäß dem ersten Ausführungsbeispiel;
Fig. 6 ein Schaubild zur Veranschaulichung des Aufbaus einer Nachricht, die von einer Teilnehmerstation des Bussystems gemäß einem zweiten Ausführungsbeispiel gesendet werden kann;
Fig. 7 ein Schaubild zur Veranschaulichung des Aufbaus einer Nachricht, die von einer Teilnehmerstation des Bussystems gemäß einem dritten Ausführungsbeispiel gesendet werden kann.
Fig. 8 ein Schaubild zur Veranschaulichung des Aufbaus einer Nachricht, die von einer Teilnehmerstation des Bussystems gemäß einem vierten Ausführungsbeispiel gesendet werden kann;
Fig. 9 ein Schaubild zur Veranschaulichung des Aufbaus einer Nachricht, die von einer Teilnehmerstation des Bussystems gemäß einem fünften Ausführungsbeispiel gesendet werden kann; und
Fig. 10 ein Schaubild zur Veranschaulichung des Aufbaus einer Nachricht, die von einer Teilnehmerstation des Bussystems gemäß einem sechsten Ausführungsbeispiel gesendet werden kann.

In den Figuren sind gleiche oder funktionsgleiche Elemente, sofern nichts anderes angegeben ist, mit denselben Bezugszeichen versehen.

### Beschreibung der Ausführungsbeispiele

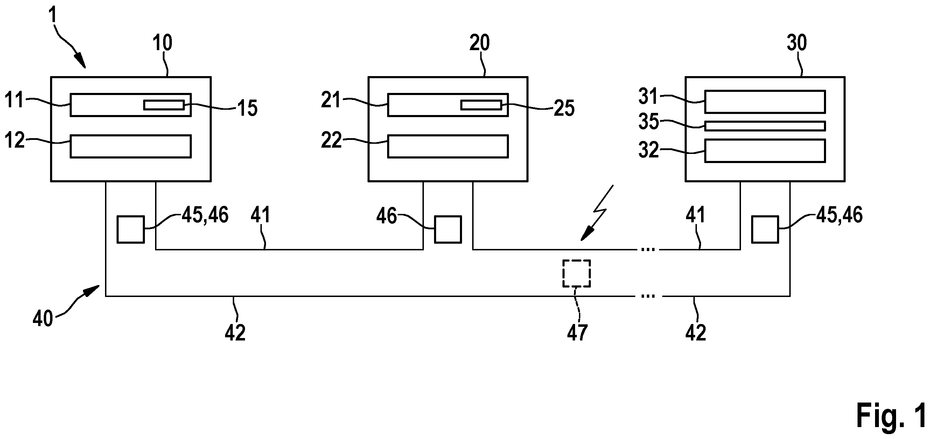

Fig. 1 zeigt als Beispiel ein Bussystem 1, das insbesondere grundlegend für ein CAN-Bussystem, ein CAN FD-Bussystem, ein CAN XL-Bussystem, und/oder Abwandlungen davon ausgestaltet ist, wie nachfolgend beschrieben. Das Bussystem 1 kann in einem Fahrzeug, insbesondere einem Kraftfahrzeug, einem Flugzeug, usw., oder im Krankenhaus usw. Verwendung finden.

In Fig. 1 hat das Bussystem 1 eine Vielzahl von Teilnehmerstationen 10, 20, 30, die jeweils an einen Bus 40 mit einer ersten Busader 41 und einer zweiten Busader 42 angeschlossen sind. Die Busadern 41, 42 können auch CAN_H und CAN_L oder CAN-XL_H und CAN-XL_L genannt werden und dienen zur elektrischen Signalübertragung nach Einkopplung der dominanten Pegel bzw. Erzeugung von rezessiven Pegeln oder anderen Pegeln für ein Signal im Sendezustand. Über den Bus 40 sind Nachrichten 45, 46 in der Form von Signalen zwischen den einzelnen Teilnehmerstationen 10, 20, 30 seriell übertragbar. Tritt bei der Kommunikation auf dem Bus 40 ein Fehler auf, wie durch den gezackten schwarzen Blockpfeil in Fig. 1 dargestellt, kann optional ein Fehlerrahmen 47 (Error Flag) gesendet werden. Die Teilnehmerstationen 10, 20, 30 sind beispielsweise Steuergeräte, Sensoren, Anzeigevorrichtungen, usw. eines Kraftfahrzeugs.

Wie in Fig. 1 gezeigt, hat die Teilnehmerstation 10 eine Kommunikationssteuereinrichtung 11, eine Sende-/Empfangseinrichtung 12 und ein Rahmenprüfmodul 15. Die Teilnehmerstation 20 hat eine Kommunikationssteuereinrichtung 21 und eine Sende-/Empfangseinrichtung 22. Die Teilnehmerstation 30 hat eine Kommunikationssteuereinrichtung 31, eine Sende-/Empfangseinrichtung 32 und ein Rahmenprüfmodul 35. Die Sende-/Empfangseinrichtungen 12, 22, 32 der Teilnehmerstationen 10, 20, 30 sind jeweils direkt an den Bus 40 angeschlossen, auch wenn dies in Fig. 1 nicht veranschaulicht ist.

Die Kommunikationssteuereinrichtungen 11, 21, 31 dienen jeweils zur Steuerung einer Kommunikation der jeweiligen Teilnehmerstation 10, 20, 30 über den Bus 40 mit mindestens einer anderen Teilnehmerstation der Teilnehmerstationen 10, 20, 30, die an den Bus 40 angeschlossen sind.

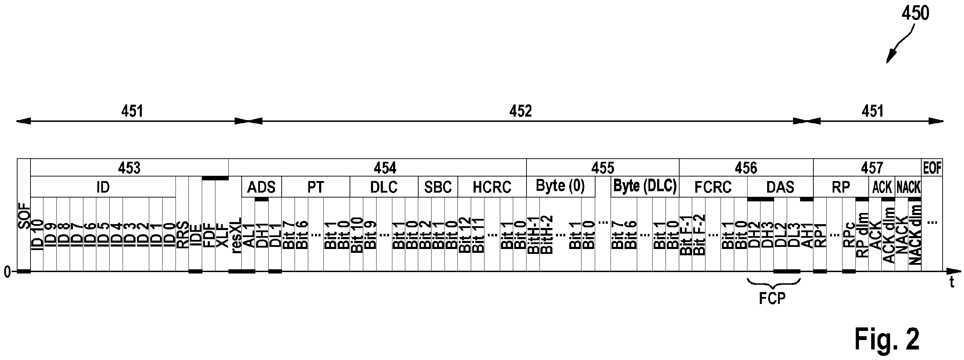

Die Kommunikationssteuereinrichtungen 11, 31 erstellen und lesen erste Nachrichten 45, die beispielsweise modifizierte CAN Nachrichten 45 sind. Hierbei sind die modifizierten CAN Nachrichten 45 auf der Grundlage eines CAN XL-Formats aufgebaut, das in Bezug auf Fig. 2 detaillierter beschrieben ist, und bei welchem das jeweilige Rahmenprüfmodul 15, 35 zum Einsatz kommt. Die Kommunikationssteuereinrichtungen 11, 31 können zudem ausgeführt sein, um je nach Bedarf eine CAN XL-Nachricht 45 oder eine CAN FD-Nachricht 46 für die Sende-/Empfangseinrichtung 32 bereitzustellen oder von dieser zu empfangen. Auch hierbei kommen die jeweiligen Rahmenprüfmodule 15, 35 zum Einsatz. Die Kommunikationssteuereinrichtungen 11, 31 erstellen und lesen also eine erste Nachricht 45 oder zweite Nachricht 46, wobei sich die erste und zweite Nachricht 45, 46 durch ihren Datenübertragungsstandard unterscheiden, nämlich in diesem Fall CAN XL oder CAN FD.

Die Kommunikationssteuereinrichtung 21 kann wie ein herkömmlicher CAN-Controller nach ISO 11898-1:2015 ausgeführt sein, d.h. wie ein CAN FD toleranter Classical CAN-Controller oder ein CAN FD Controller. Die Kommunikationssteuereinrichtung 21 erstellt und liest zweite Nachrichten 46, beispielsweise CAN FD-Nachrichten 46. Bei den CAN FD-Nachrichten 46 kann eine Anzahl von 0 bis zu 64 Datenbytes umfasst sein, die noch dazu mit einer deutlich schnelleren Datenrate als bei einer Classical CAN-Nachrichtübertragen werden. Insbesondere ist die Kommunikationssteuereinrichtung 21 wie ein herkömmlicher CAN FD-Controller ausgeführt.

Die Sende-/Empfangseinrichtung 22 kann wie ein herkömmlicher CAN Transceiver nach ISO 11898-1:2015 oder CAN FD Transceiver ausgeführt sein. Die Sende-/Empfangseinrichtungen 12, 32 können ausgeführt sein, um je nach Bedarf Nachrichten 45 gemäß dem CAN XL-Format oder Nachrichten 46 gemäß dem derzeitigen CAN FD-Format für die zugehörige Kommunikationssteuereinrichtung 11, 31 bereitzustellen oder von dieser zu empfangen.

Mit den beiden Teilnehmerstationen 10, 30 ist eine Bildung und dann Übertragung von Nachrichten 45 mit dem CAN XL Format sowie der Empfang solcher Nachrichten 45 realisierbar.

Fig. 2 zeigt für die Nachricht 45 einen CAN XL Rahmen 450, wie er von der Kommunikationssteuereinrichtung 11 für die Sende-/Empfangseinrichtung 12 zum Senden auf den Bus 40 bereitgestellt wird. Hierbei erstellt die Kommunikationssteuereinrichtung 11 den Rahmen 450 bei dem vorliegenden Ausführungsbeispiel als kompatibel mit CAN FD, wie auch in Fig. 2 veranschaulicht. Dasselbe gilt analog für die Kommunikationssteuereinrichtung 31 und die Sende-/Empfangseinrichtung 32 der Teilnehmerstation 30.

Gemäß Fig. 2 ist der CAN XL-Rahmen 450 für die CAN-Kommunikation auf dem Bus 40 in unterschiedliche Kommunikationsphasen 451, 452 unterteilt, nämlich eine Arbitrationsphase 451 und eine Datenphase 452. Der Rahmen 450 hat ein Arbitrationsfeld 453, ein Steuerfeld 454, ein Datenfeld 455, ein Prüfsummenfeld 456 für eine Prüfsumme FCRC und eine Umschaltsequenz ADS sowie ein Bestätigungsfeld 457.

In der Arbitrationsphase 451 wird mit Hilfe eines Identifizierers (ID) in dem Arbitrationsfeld 453 bitweise zwischen den Teilnehmerstationen 10, 20, 30 ausgehandelt, welche Teilnehmerstation 10, 20, 30 die Nachricht 45, 46 mit der höchsten Priorität senden möchte und daher für die nächste Zeit zum Senden in der anschließenden Datenphase 452 einen exklusiven Zugriff auf den Bus 40 des Bussystems 1 bekommt. In der Arbitrationsphase 451 wird ein Physical Layer wie bei CAN und CAN-FD verwendet. Der Physical Layer entspricht der Bitübertragungsschicht oder Schicht 1 des bekannten OSI-Modells (Open Systems Interconnection Modell).

Ein wichtiger Punkt während der Phase 451 ist, dass das bekannte CSMA/CR-Verfahren Verwendung findet, welches gleichzeitigen Zugriff der Teilnehmerstationen 10, 20, 30 auf den Bus 40 erlaubt, ohne dass die höher priorisierte Nachricht 45, 46 zerstört wird. Dadurch können dem Bussystem 1 relativ einfach weitere Bus-Teilnehmerstationen 10, 20, 30 hinzugefügt werden, was sehr vorteilhaft ist.

Das CSMA/CR-Verfahren hat zur Folge, dass es sogenannte rezessive Zustände auf dem Bus 40 geben muss, welche von anderen Teilnehmerstationen 10, 20, 30 mit dominanten Zuständen auf dem Bus 40 überschrieben werden können. Im rezessiven Zustand herrschen an der einzelnen Teilnehmerstation 10, 20, 30 hochohmige Verhältnisse, was in Kombination mit den Parasiten der Busbeschaltung längere Zeitkonstanten zur Folge hat. Dies führt zu einer Begrenzung der maximalen Bitrate des heutigen CAN-FD-Physical-Layer auf derzeit etwa 2 Megabit pro Sekunde im realen Fahrzeug-Einsatz.

In der Datenphase 452 werden neben einem Teil des Steuerfelds 454 die Nutzdaten des CAN-XL-Rahmens bzw. der Nachricht 45 aus dem Datenfeld 455 sowie das Prüfsummenfeld 456 für die Prüfsumme FCRC und außerdem ein Feld DAS gesendet, das zur Umschaltung von der Datenphase 452 zurück zur Arbitrationsphase 451 dient.

Ein Sender der Nachricht 45 beginnt ein Senden von Bits der Datenphase 452 auf den Bus 40 erst, wenn die Teilnehmerstation 10 als der Sender die Arbitration gewonnen hat und die Teilnehmerstation 10 als Sender damit zum Senden einen exklusiven Zugriff auf den Bus 40 des Bussystems 1 hat.

Ganz allgemein können in dem Bussystem mit CAN XL im Vergleich zu CAN oder CAN FD folgende abweichenden Eigenschaften realisiert werden:
a) Übernahme und ggf. Anpassung bewährter Eigenschaften, die für die Robustheit und Anwenderfreundlichkeit von CAN und CAN FD verantwortlich sind, insbesondere Rahmenstruktur mit Identifier und Arbitrierung nach dem CSMA/CR-Verfahren,
b) Steigerung der Netto-Datenübertragungsrate, insbesondere auf etwa 10 Megabit pro Sekunde,
c) Anheben der Größe der Nutzdaten pro Rahmen, insbesondere auf etwa 4kbyte oder einen beliebigen anderen Wert.

Wie in Fig. 2 dargestellt, verwendet die Teilnehmerstation 10 in der Arbitrationsphase 451 als erster Kommunikationsphase teilweise, insbesondere bis zum FDF-Bit (inklusive), ein von CAN/CAN-FD bekanntes Format gemäß der ISO11898-1:2015. Dagegen verwendet die Teilnehmerstation 10 ab dem FDF-Bit in der ersten Kommunikationsphase sowie in der zweiten Kommunikationsphase, der Datenphase 452, ein CAN XL Format, das nachfolgend beschrieben ist.

Bei dem vorliegenden Ausführungsbeispiel sind CAN XL und CAN FD kompatibel. Hierbei wird das von CAN FD bekannte res-Bit, das nachfolgend XLF-Bit genannt ist, für die Umschaltung von dem CAN FD Format zu dem CAN XL Format genutzt. Daher sind die Rahmenformate von CAN FD und CAN XL bis zum res-Bit gleich. Ein Empfänger erkennt erst bei dem res-Bit, in welchem Format der Rahmen gesendet wird. Eine CAN XL Teilnehmerstation, also hier die Teilnehmerstationen 10, 30, unterstützt auch CAN FD.

Alternativ zu dem in Fig. 2 gezeigten Rahmen 450, bei welchem ein Identifizierer (Identifier) mit 11 Bit verwendet wird, ist optional ein CAN XL Erweitertes Rahmenformat möglich, bei dem ein Identifizierer (Identifier) mit 29 Bit verwendet wird. Dies ist bis zum FDF-Bit identisch zu dem bekannten CAN FD Erweiterten Rahmenformat aus der ISO11898-1:2015.

Gemäß Fig. 2 ist der Rahmen 450 vom SOF-Bit bis einschließlich zum FDF-Bit identisch zum CAN FD Base Frame Format gemäß der ISO11898-1:2015. Daher ist der bekannte Aufbau hier nicht weiter erläutert. Bits, die an ihrer unteren Linie in Fig. 2 mit einem dicken Strich dargestellt sind, werden in dem Rahmen 450 als dominant oder ,0' gesendet. Bits, die an ihrer oberen Linie in Fig. 2 mit einem dicken Strich dargestellt sind, werden in dem Rahmen 450 als rezessiv oder ,1' gesendet. In der CAN XL Datenphase 452 werden symmetrische ,1' und ,0' Pegel verwendet, statt rezessiver und dominanter Pegel.

Allgemein werden bei der Erzeugung des Rahmens 450 zwei unterschiedliche Stuffing-Regeln angewendet. Bis zum XLF-Bit im Steuerfeld 454 gilt die dynamische Bit-Stuffing-Regel von CAN FD, so dass nach 5 gleichen Bits in Folge ein inverses Stuff-Bit einzufügen ist. Derartige Stuff-Bits werden auch als dynamische Stuff-Bits bezeichnet. Nach einem resXL-Bit im Steuerfeld 454 gilt eine feste Stuffing-Regel, so dass nach einer festen Zahl von Bits ein fixed Stuff-Bit einzufügen ist. Alternativ können statt nur einem Stuff-Bit eine Anzahl von 2 oder mehr Bits als fixed Stuff-Bits eingefügt werden, wie auch später noch genauer beschrieben.

In dem Rahmen 450 folgt direkt nach dem FDF-Bit das XLF-Bit, das von der Position her dem "res Bit" im CAN FD Base Frame Format entspricht, wie zuvor erwähnt. Wird das XLF-Bit als 1, also rezessiv, gesendet, identifiziert es damit den Rahmen 450 als CAN XL-Rahmen. Für einen CAN FD Rahmen setzt die Kommunikationssteuereinrichtung 11 das XLF-Bit als 0, also dominant.

Nach dem XLF-Bit folgt in dem Rahmen 450 ein resXL-Bit, das ein dominantes Bit für die zukünftige Nutzung ist. Das resXL muss für den Rahmen 450 als 0, also dominant, gesendet werden. Empfängt die Teilnehmerstation 10 jedoch ein resXL-Bit als 1, also rezessiv, geht die empfangende Teilnehmerstation 10 beispielsweise in einen Protokollausnahmezustand (Protocoll Exception State), so wie es bei einer CAN FD Nachricht 46 für ein res=1 ausgeführt wird. Alternativ könnte das resXL-Bit genau umgekehrt definiert sein, also, dass es als 1, also rezessiv, gesendet werden muss. In diesem Fall geht die empfangende Teilnehmerstation bei einem dominanten resXL-Bit in den Protokollausnahmezustand.

Nach dem resXL-Bit folgt in dem Rahmen 450 eine Sequenz ADS (Arbitration Data Switch), in welcher eine vorbestimmte Bitsequenz codiert wird. Diese Bitsequenz erlaubt eine einfache und sichere Umschaltung von der Bitrate der Arbitrationsphase 451 (Arbitrtationsbitrate) zu der Bitrate der Datenphase 452 (Datenbitrate). Beispielsweise besteht die Bitsequenz der ADS-Sequenz unter anderem aus einem AL1-Bit, das dominant, also 0, gesendet wird. Das AL1-Bit ist das letzte Bit der Arbitrationsphase 451. Mit anderen Worten, das AL1-Bit ist das letzte Bit vor der Umschaltung in die Datenphase 452 mit den kurzen Bits. Innerhalb des AL1-Bits wird der Physical Layer in der Sende-/Empfangseinrichtung 12, 22, 32 umgeschaltet. Das AL1 Bit könnte auch den Wert 1 haben, je nachdem welcher Wert (0 oder 1) für die Umschaltung des Physical Layers in der Sende-/Empfangseinrichtung 12, 32 (Transceiver) besser geeignet ist. Die zwei folgenden Bits DH1 und DL1 werden bereits mit der Datenbitrate gesendet. Somit sind die Bits DH1 und DL1 bei CAN XL zeitlich kurze Bits der Datenphase 452.

Nach der Sequenz ADS folgt in dem Rahmen 450 ein PT-Feld, das den Inhalt des Datenfeldes 455 kennzeichnet. Der Inhalt gibt an, welche Art von Information in dem Datenfeld 455 enthalten ist. Beispielsweise gibt das PT-Feld an, ob sich im Datenfeld 455 ein "Internet Protocol" (IP) Rahmen befinden, oder ein getunnelter Ethernet Rahmen oder sonstiges.

An das PT-Feld schließt sich ein DLC-Feld an, in welchem der Datenlängencode (DLC = Data Length Code) eingefügt wird, welcher die Anzahl der Bytes im Datenfeld 455 des Rahmens 450 angibt. Der Datenlängencode (DLC) kann jeden Wert von 0 bis zur maximalen Länge des Datenfelds 455 bzw. Datenfeldlänge annehmen. Beträgt die maximale Datenfeldlänge insbesondere 2048 Bit, benötigt der Datenlängencode (DLC) eine Anzahl von 11 Bits unter den Annahmen, dass DLC = 0 eine Datenfeldlänge mit einer Anzahl von 1 Byte bedeutet und DLC = 2047 eine Datenfeldlänge mit einer Anzahl von 2048 Byte Datenfeldlänge bedeutet. Alternativ könnte ein Datenfeld 455 der Länge 0 erlaubt sein, wie beispielsweise bei CAN. Hierbei würde DLC = 0 beispielsweise die Datenfeldlänge mit der Anzahl von 0 Bytes codieren. Die maximale codierbare Datenfeldlänge ist mit beispielsweise 11 Bit dann (2^11)-1 = 2047.

Nach dem DLC-Feld folgt bei dem Beispiel von Fig. 2 in dem Rahmen 450 ein SBC-Feld. Die Abkürzung SBC steht für "Stuff Bit Count". Das SBC-Feld kodiert die Zahl der dynamischen Stuff-Bits im Kopf (Header) des Rahmens 450. Das SBC-Feld kann prinzipiell an jeder Stelle im Kopf (Header) des Rahmens 450 zwischen dem ADS-Feld und dem Ende des Kopfs (Header) des Rahmens 450 platziert werden. Vorteilhaft ist eine Platzierung des SBC-Felds vor eine Kopfprüfsumme HCRC, damit das SBC-Feld von der Kopfprüfsumme HCRC abgesichert werden kann.

Nach dem SBC-Feld folgt in dem Rahmen 450 von Fig. 2 eine Kopfprüfsumme HCRC. Die Kopfprüfsumme HCRC ist eine Prüfsumme zur Absicherung des Kopfes (Headers) des Rahmens 450, das heißt aller relevanten Bits vom Beginn des Rahmens 450 mit dem SOF-Bit bis zum Beginn der Kopfprüfsumme HCRC, inklusive aller dynamischen und optional der fixed Stuff-Bits bis zum Beginn der Kopfprüfsumme HCRC. Die relevanten Bits umfassen nur die Bits des Rahmenkopfes, die einen veränderbaren Wert haben. Mit anderen Worten, die relevanten Bits umfassen keine Bits, die in dem Rahmen 450 immer einen festen Wert haben. Derartige Bits mit nicht veränderbarem Wert werden also nicht abgesichert, denn diese Bits haben einen festen Wert. Die Länge der Kopfprüfsumme HCRC und damit des Prüfsummen-Polynoms gemäß der zyklischen Redundanzprüfung (CRC) ist entsprechend der gewünschten Hamming-Distanz zu wählen. Das von der Kopfprüfsumme HCRC abzusichernde Datenwort ist bei einem Datenlängencode (DLC) von 11 Bit länger als 27 Bit. Daher muss das Polynom der Kopfprüfsumme HCRC, um eine Hamming-Distanz von 6 zu erreichen, mindestens 13 Bit lang sein.

Nach der Kopfprüfsumme HCRC folgt in dem Rahmen 450 das Datenfeld 455 (Data Field). Das Datenfeld 455 besteht aus 1 bis n Daten-Bytes, wobei n beispielsweise 2048 Byte oder 4096 Byte oder ein beliebiger anderer Wert ist. Alternativ ist eine Datenfeldlänge von 0 denkbar. Die Länge des Datenfelds 455 ist in dem DLC-Feld codiert, wie zuvor beschrieben.

Nach dem Datenfeld 455 folgt in dem Rahmen 450 eine Rahmenprüfsumme FCRC. Die Rahmenprüfsumme FCRC besteht aus den Bits der Rahmenprüfsumme FCRC. Die Länge der Rahmenprüfsumme FCRC und damit des CRC Polynoms ist entsprechend der gewünschten Hamming-Distanz zu wählen. Die Rahmenprüfsumme FCRC sichert den gesamten Rahmen 450 ab. Alternativ ist optional nur das Datenfeld 455 mit der Rahmenprüfsumme FCRC abgesichert.

Nach der Rahmenprüfsumme FCRC folgt in dem Rahmen 450 die Sequenz DAS (Data Arbitration Switch), in welcher eine vorbestimmte Bitsequenz codiert wird. Diese Bitsequenz erlaubt eine einfache und sichere Umschaltung von der DatenBitrate der Datenphase 452 zu der Arbitrations-Bitrate der Arbitrationsphase 451. Beispielsweise beginnt die Bit Sequenz mit den Datenbits DH2, DH3 die als 1 gesendet werden und den Datenbits DL2, DL3 die als 0 gesendet werden, wie in Fig. 2 gezeigt. Das sind die letzten 4 Bits der Datenphase 452. Somit ist das DL3-Bit das letzte kurze Bit, d.h. das letzte Bit vor der Umschaltung in die Arbitrationsphase 451 mit den langen Bits. Die Bits werden gefolgt von einem AH1-Bit mit dem Wert 1 der Arbitrations-Phase 451. Innerhalb des AH1-Bits wird der Physical Layer in der Sende-/Empfangseinrichtung 12, 32 (Transceiver) umgeschaltet. Das AH1-Bit könnte alternativ den Wert 0 haben, je nachdem welcher Wert (0 oder 1) für die Umschaltung des Physical Layers in der Sende-/Empfangseinrichtung 12, 32 (Transceiver) besser geeignet ist. Eine RX-Teilnehmerstation 10, 30, die nur Empfänger des Rahmens 450 ist, also den empfangenen Rahmen 450 nicht gesendet hat, verwendet die Bitsequenz DH2, DH3, DL2, DL3 nicht nur zur Synchronisation, sondern auch als Formatprüfmuster (Format Check Pattern). Mit dieser Bitsequenz kann die RX-Teilnehmerstation 10, 30 erkennen, ob sie den von dem Bus 40 empfangenen Bitstrom versetzt abtastet, beispielsweise um 1 Bit oder 2 Bit, usw.. Gemäß noch einem anderen Beispiel hat das DAS-Feld drei Bits, also das DH2-Bit, das DL2-Bit und ein AH1-Bit. Von den Bits werden das erste und letzte Bit als 1 gesendet und das mittlere Bit als 0 gesendet.

Bei den obigen Beispielen kann an der Flanke zwischen dem DH3-Bit und dem DL2-Bit bzw. dem DH2-Bit und dem DL2-Bit in der empfangenden Teilnehmerstation die letzte Synchronisation vor der Umschaltung von der Datenphase 452 in die Arbitrationsphase 451 durchgeführt werden.

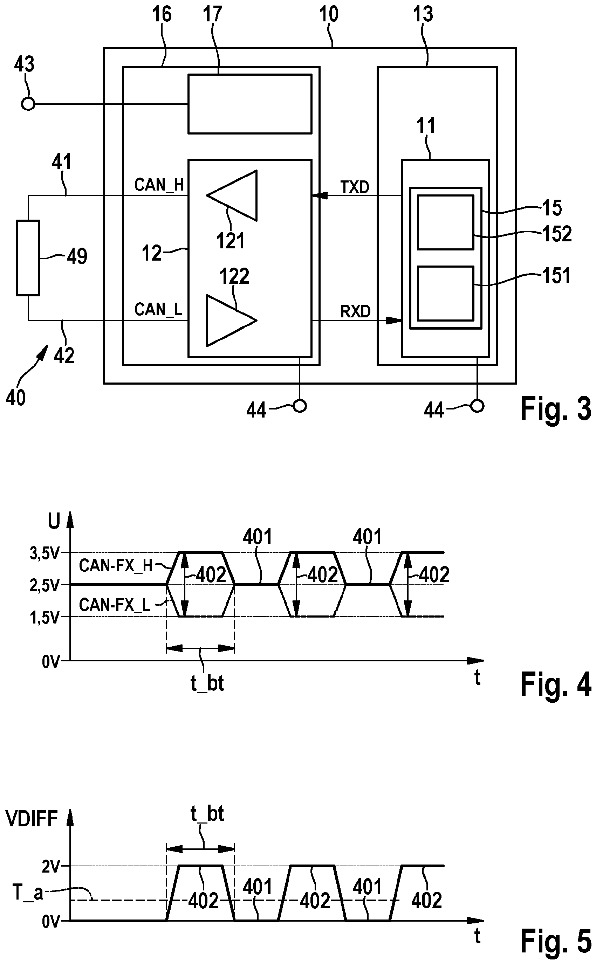

Somit ist bei dem vorliegenden Ausführungsbeispiel in der Sequenz DAS ein Formatprüfmuster (FCP = Format Check Pattern) enthalten, mit welchem die Teilnehmerstationen 10, 30, insbesondere ihre Rahmenprüfmodule 15, 35, in der Lage sind, in einem empfangenen Rahmen 450 einen Versatz des Bitstroms zu detektieren, auch wenn die zugehörige Teilnehmerstationen 10, 30 kein Sender, sondern nur Empfänger des Rahmens 450 ist. Hierbei gilt, je länger das Bitmuster des FCP-Felds ist, desto größer oder stärker ist die Verschiebung, die in der empfangenden Teilnehmerstation 10, 30 detektiert werden kann. as vorteilhafteste Bitmuster für die Verschiebungsdetektion enthält eine gerade Zahl von M Bits, wobei die ersten M/2 Bits eine 1 enthalten und die folgenden M/2 Bits eine 0. Bei dem Beispiel von Fig. 2 mit einem FCP-Feld mit 4 Bits werden die ersten beiden Bits als rezessiv, also 1, gesendet. Die beiden letzten Bits des FCP-Felds werden als dominant, also 0, gesendet. Somit weicht das FCP-Feld mit vier Bits gemäß Fig. 2, wegen der zusätzlichen Bits DH3, DL3, von den üblichen zwei Bits am Anfang des FCP-Felds ab. Jedoch kann die Flanke von rezessiv zu dominant in dem FCP-Feld von Fig. 2 die gleiche Funktion erfüllen wie in einem DAS-Feld, das die Bits DH3, DL3 nicht aufweist. Ganz allgemein ist es möglich, dass in dem FCP-Feld die ersten M/2 Bits eine 0 enthalten und die folgenden M/2 Bits eine 1. Mit dem Feld FCP kann ein Versatz um M-1 erkannt werden. Dies ist nachfolgend in Bezug auf Fig. 3 noch genauer beschrieben.

Nach der Sequenz DAS folgt in dem Rahmen 450 das Bestätigungsfeld 457, das mit einem RP-Feld beginnt. In dem RP-Feld ist ein Synchronisationsmuster (Sync Pattern) vorgehalten, das einer empfangenden Teilnehmerstation 10, 30 erlaubt, den Beginn der Arbitrationsphase 451 nach der Datenphase 452 zu erkennen. Das Synchronisationsmuster erlaubt empfangenden Teilnehmerstationen 10, 30, die beispielsweise aufgrund einer falschen Kopfprüfsumme HCRC die korrekte Länge des Datenfelds 455 nicht kennen, sich aufzusynchronisieren. Anschließend können diese Teilnehmerstationen ein "Negativ Acknowledge" senden, um den fehlerhaften Empfang mitzuteilen. Dies ist insbesondere dann sehr wichtig, wenn CAN XL im Datenfeld 455 keine Fehlerrahmen 47 (Error Flags) erlaubt.

Nach dem RP-Feld folgen in dem Bestätigungsfeld (ACK Field) 457 mehrere Bits zur Bestätigung oder Nichtbestätigung eines korrekten Empfangs des Rahmens 450. Bei dem Beispiel von Fig. 2 sind ein ACK-Bit, ein ACK-dlm-Bit, ein NACK-Bit und ein NACK-dlm-Bit vorgesehen. Das NACK-Bit und das NACK-dlm-Bit sind optionale Bits. Das ACK-Bit senden die empfangenden Teilnehmerstationen 10, 30 als dominant, wenn sie den Rahmen 450 korrekt empfangen haben. Die sendende Teilnehmerstation sendet das ACK-Bit als rezessiv. Daher kann das ursprünglich in dem Rahmen 450 auf den Bus 40 gesendete Bit von den empfangenden Teilnehmerstationen 10, 30 überschrieben werden. Das ACK-dlm-Bit wird als ein rezessives Bit gesendet, welches zur Abtrennung zu anderen Feldern dient. Das NACK-Bit und das NACK-dlm Bit dienen dazu, dass eine empfangende Teilnehmerstation einen nicht korrekten Empfang des Rahmens 450 auf dem Bus 40 signalisieren kann. Die Funktion der Bits ist wie die des ACK-Bits und des ACK-dlm-Bits.

Nach dem Bestätigungsfeld (ACK Field) 457 folgt in dem Rahmen 450 ein Endefeld (EOF = End of Frame). Die Bitsequenz des Endefelds (EOF) dient dazu, das Ende des Rahmens 450 zu kennzeichnen. Das Endefeld (EOF) sorgt dafür, dass am Ende des Rahmens 450 eine Anzahl von 8 rezessiven Bits gesendet wird. Das ist eine Bitfolge, die innerhalb des Rahmens 450 nicht auftreten kann. Dadurch kann von den Teilnehmerstationen 10, 20, 30 das Ende des Rahmens 450 sicher erkannt werden.

Das Endefeld (EOF) hat eine Länge, die abhängig davon unterschiedlich ist, ob im NACK-Bit ein dominantes Bit oder ein rezessives Bit gesehen wurde. Wenn die sendende Teilnehmerstation das NACK-Bit als dominant empfangen hat, dann hat das Endefeld (EOF) eine Anzahl von 7 rezessiven Bits. Ansonsten ist das Endefeld (EOF) nur 5 rezessive Bits lang.

Nach dem Endefeld (EOF) folgt in dem Rahmen 450 ein Zwischenrahmenabstand (IFS - Inter Frame Space), der in Fig. 2 nicht dargestellt ist. Dieser Zwischenrahmenabstand (IFS) ist ausgestaltet wie bei CAN FD entsprechend der ISO11898-1:2015.

Fig. 3 zeigt den grundlegenden Aufbau der Teilnehmerstation 10 mit der Kommunikationssteuereinrichtung 11, der Sende-/Empfangseinrichtung 12 und dem Rahmenprüfmodul 15, das Teil der Kommunikationssteuereinrichtung 11 ist. Die Teilnehmerstation 30 ist in ähnlicher Weise aufgebaut, wie in Fig. 3 gezeigt, jedoch ist das Rahmenprüfmodul 35 gemäß Fig. 1 separat von der Kommunikationssteuereinrichtung 31 und der Sende-/Empfangseinrichtung 32 angeordnet. Daher wird die Teilnehmerstation 30 nicht separat beschrieben.

Gemäß Fig. 3 hat die Teilnehmerstation 10 zusätzlich zu der Kommunikationssteuereinrichtung 11 und der Sende-/Empfangseinrichtung 12 einen Mikrocontroller 13, welchem die Kommunikationssteuereinrichtung 11 zugeordnet ist, und eine System-ASIC 16 (ASIC = Anwendungsspezifische Integrierte Schaltung), die alternativ ein System Basis-Chip (SBC) sein kann, auf dem mehrere für eine Elektronik-Baugruppe der Teilnehmerstation 10 notwendige Funktionen zusammengefasst sind. In dem System-ASIC 16 ist zusätzlich zu der Sende-/Empfangseinrichtung 12 eine Energieversorgungseinrichtung 17 eingebaut, welche die Sende-/Empfangseinrichtung 12 mit elektrischer Energie versorgt. Die Energieversorgungseinrichtung 17 liefert üblicherweise eine Spannung CAN_Supply von 5 V. Je nach Bedarf kann die Energieversorgungseinrichtung 17 jedoch eine andere Spannung mit einem anderen Wert liefern. Zusätzlich oder alternativ kann die Energieversorgungseinrichtung 17 als Stromquelle ausgestaltet sein.

Das Rahmenprüfmodul 15 hat einen Einfügeblock 151 und einen Auswerteblock 152, die nachfolgend noch genauer beschrieben sind.

Die Sende-/Empfangseinrichtung 12 hat zudem ein Sendemodul 121 und ein Empfangsmodul 122. Auch wenn nachfolgend immer von der Sende-/Empfangseinrichtung 12 gesprochen ist, ist es alternativ möglich, das Empfangsmodul 122 in einer separaten Einrichtung extern von dem Sendemodul 121 vorzusehen. Das Sendemodul 121 und das Empfangsmodul 122 können wie bei einer herkömmlichen Sende-/Empfangseinrichtung 22 aufgebaut sein. Das Sendemodul 121 kann insbesondere mindestens einen Operationsverstärker und/oder einen Transistor aufweisen. Das Empfangsmodul 122 kann insbesondere mindestens einen Operationsverstärker und/oder einen Transistor aufweisen.

Die Sende-/Empfangseinrichtung 12 ist an den Bus 40 angeschlossen, genauer gesagt dessen erste Busader 41 für CAN_H oder CAN-XL_H und dessen zweite Busader 42 für CAN_L oder CAN-XL_L. Über mindestens einen Anschluss 43 erfolgt die Spannungsversorgung für die Energieversorgungseinrichtung 17 zum Versorgen der ersten und zweiten Busader 41, 42 mit elektrischer Energie, insbesondere mit der Spannung CAN-Supply. Die Verbindung mit Masse bzw. CAN_GND ist über einen Anschluss 44 realisiert. Die erste und zweite Busader 41, 42 sind mit einem Abschlusswiderstand 49 terminiert.

Die erste und zweite Busader 41, 42 sind in der Sende-/Empfangseinrichtung 12 nicht nur mit dem Sendemodul 121, das auch als Transmitter bezeichnet wird, und mit dem Empfangsmodul 122 verbunden, das auch als Receiver bezeichnet wird, auch wenn die Verbindung in Fig. 3 zur Vereinfachung nicht gezeigt ist.

Im Betrieb des Bussystems 1 setzt das Sendemodul 121 ein Sendesignal TXD oder TxD der Kommunikationssteuereinrichtung 11 in entsprechende Signale CAN-XL_H und CAN-XL_L für die Busadern 41, 42 um und sendet diese Signale CAN-XL_H und CAN-XL_L an den Anschlüssen für CAN_H und CAN_L auf den Bus 40.

Das Empfangsmodul 122 bildet aus von Bus 40 empfangenen Signalen CAN-XL_H und CAN-XL_L gemäß Fig. 4 ein Empfangssignal RXD oder RxD und gibt dieses an die Kommunikationssteuereinrichtung 11 weiter, wie in Fig. 3 gezeigt. Mit Ausnahme eines Leerlauf- oder Bereitschaftszustands (Idle oder Standby), hört die Sende-/Empfangseinrichtung 12 mit dem Empfangsmodul 122 im Normalbetrieb immer auf eine Übertragung von Daten bzw. Nachrichten 45, 46 auf dem Bus 40 und zwar unabhängig davon, ob die Sende-/Empfangseinrichtung 12 Sender der Nachricht 45 ist oder nicht.

Gemäß dem Beispiel von Fig. 4 haben die Signale CAN-XL_H und CAN-XL_L zumindest in der Arbitrationsphase 451 die dominanten und rezessiven Buspegel 401, 402, wie von CAN bekannt. Auf dem Bus 40 bildet sich ein Differenzsignal VDIFF = CAN-XL_H - CAN-XL_L aus, das in Fig. 5 gezeigt ist. Die einzelnen Bits des Signals VDIFF mit der Bitzeit t_bt können mit einer Empfangsschelle von 0,7 V erkannt werden. In der Datenphase 452 werden die Bits der Signale CAN-XL_H und CAN-XL_L schneller, also mit einer kürzeren Bitzeit t_bt, gesendet als in der Arbitrationsphase 451. Somit unterscheiden sich die Signale CAN-XL_H und CAN-XL_L in der Datenphase 452 zumindest in deren schnelleren Bitrate von den herkömmlichen Signalen CAN_H und CAN_L.

Die Abfolge der Zustände 401, 402 für die Signale CAN-XL_H, CAN-XL_L in Fig. 4 und der daraus resultierende Verlauf der Spannung VDIFF von Fig. 5 dient nur der Veranschaulichung der Funktion der Teilnehmerstation 10. Die Abfolge der Datenzustände für die Buszustände 401, 402 ist je nach Bedarf wählbar.

Mit anderen Worten erzeugt das Sendemodul 121 in einer ersten Betriebsart gemäß Fig. 4 einen ersten Datenzustand als Buszustand 402 mit unterschiedlichen Buspegeln für zwei Busadern 41, 42 der Busleitung und einen zweiten Datenzustand als Buszustand 401 mit demselben Buspegel für die zwei Busadern 41, 42 der Busleitung des Busses 40.

Außerdem sendet das Sendemodul 121, für die zeitlichen Verläufe der Signale CAN-XL_H, CAN-XL_L in einer zweiten Betriebsart, welche die Datenphase 452 umfasst, die Bits mit einer höheren Bitrate auf den Bus 40. Die CAN-XL_H und CAN-XL_L Signale können in der Datenphase 452 zudem mit einem anderen Physical Layer als bei CAN FD erzeugt werden. Dadurch kann die Bitrate in der Datenphase 452 noch weiter erhöht werden als bei CAN FD.

Das Rahmenprüfmodul 15 von Fig. 3, insbesondere dessen Einfügeblock 151, dient zum Einfügen des SBC-Felds in den Rahmen 450, wenn die Teilnehmerstation 10 als Sender des Rahmens 450 agiert. Das Rahmenprüfmodul 15 von Fig. 3 ist bei dem vorliegenden Ausführungsbeispiel derart ausgestaltet, dass das SBC-Feld drei Bits hat, also ein BitO, ein Bit1 und ein Bit2. Dadurch erzeugt das SBC-Feld möglichst wenig Überhang an Daten (Daten-Overhead). In dem SBC-Feld trägt das Rahmenprüfmodul 15 in die Bits BitO und Bit1 die Anzahl der dynamischen Stuff-Bits ein und in Bit2 die Parität der ersten zwei Bits.

Der Einfügeblock 151 fügt das SBC-Feld bei dem vorliegenden Ausführungsbeispiel vor der Kopfprüfsumme HCRC im Rahmen 450 ein. Das Rahmenprüfmodul 15, insbesondere der Auswerteblock 152, verwendet auch das SBC-Feld beim Bilden der Kopfprüfsumme HCRC sowie alle dynamischen Stuff-Bits des Rahmenkopfes. Im Ergebnis sind Fehler der Klasse 3 und der Klasse 4 detektierbar.

Das Rahmenprüfmodul 15 von Fig. 3, insbesondere dessen Auswerteblock 152, dient zum Bilden und Prüfen der Kopfprüfsumme und der Rahmenprüfsumme, sowie zum Prüfen der Anzahl der dynamischen Stuff-Bits.

Der Auswerteblock 152 in der empfangenden Teilnehmerstation kann die Anzahl der empfangenen dynamischen Stuff-Bits im Rahmenkopf mit dem Wert im SBC-Feld vergleichen und somit eine Abweichung, also Fehler, im Vergleich zu der tatsächlichen Anzahl im Rahmenkopf erkennen.

Dagegen lässt der Auswerteblock 152 die dynamischen Stuff-Bits beim Bilden der Rahmenprüfsumme FCRC weg. Jedoch berechnet der Auswerteblock 152 die anderen Bits des Rahmenkopfes, wie ID-Bit, RRS-Bit, usw., in die Rahmenprüfsumme FCRC mit ein. Diese Bits sind also doppelt abgesichert. Dadurch sind mit dem Rahmenprüfmodul 15, insbesondere mit dessen Auswerteblock 152, Fehler der Klasse 3 und Klasse 4, die im Zusammenhang mit dynamischen Stuff-Bits auftreten, mit sehr hoher Wahrscheinlichkeit detektierbar.

Somit kann die empfangende Teilnehmerstation (Empfangsknoten) 10, insbesondere ihr Rahmenprüfmodul 15 und genauer ihr Auswerteblock 152, die kritischen Fehler erkennen, die mit dynamischen Stuff-Bits im empfangenen Bitstrom auftreten können. Der Auswerteblock 152 gibt eine entsprechende Mitteilung an die Kommunikationssteuereinrichtung 11 aus. Damit kann der empfangene Rahmen 450 im Falle eines Fehlers verworfen werden. In Folge dessen kann die Kommunikationssteuereinrichtung 11 optional einen Fehlerrahmen 47 zum Bus 40 senden.

Verwendet man jedoch ein "Stuff Count" Feld, wie das SBC-Feld, so reduziert man die Restfehlerwahrscheinlichkeit weiter. Demzufolge wird es noch unwahrscheinlicher, dass ein fehlerhafter Rahmen 450 als gültig akzeptiert wird.

Somit ist die Verwendung des SBC-Feldes "Stuff Counts" Feldes, welches die Zahl der dynamischen Stuff Bits im gesendeten Rahmen kodiert, optional.

Ist keine Kompatibilität zu CAN FD gefordert, so können im Rahmen z.B. anstatt dynamischen Stuff-Bits sogenannte fixed Stuff-Bits (Stuff-Bits die immer da sind) verwendet werden. Ohne dynamische Stuff-Bits können die Fehler der Klasse 3 und Klasse 4 nicht auftreten. Zudem kann ein "Stuff Count" Feld wie das SBC-Feld weggelassen werden. Dies führt zu einer geringeren Zahl von zu übertragenden Bits und sogar zu weniger Komplexität.

Gemäß einer ersten Modifikation des ersten Ausführungsbeispiels ist das Rahmenprüfmodul 15, insbesondere der Auswerteblock 152, ausgestaltet, die dynamischen Stuff-Bits beim Bilden der Kopfprüfsumme HCRC wegzulassen. Dagegen verwendet das Rahmenprüfmodul 15, insbesondere der Auswerteblock 152, die dynamischen Stuff-Bits beim Bilden der Rahmenprüfsumme FCRC. Hierbei berechnet das Rahmenprüfmodul 15, insbesondere der Auswerteblock 152, die anderen Bits des Rahmenkopfes, wie ID-Bit, RRS-Bit, usw., wieder in die Rahmenprüfsumme FCRC mit ein. Auch auf diese Weise sind die speziellen Fehler der Klassen 3 und 4 ausreichend sicher detektierbar. Die Detektion kann bei Verwendung von Fehlerrahmen 47 mit einem Fehlerrahmen 47 gemeldet werden.

Gemäß einer zweiten Modifikation des ersten Ausführungsbeispiels ist das Rahmenprüfmodul 15, insbesondere der Auswerteblock 152, ausgestaltet, in keine der Prüfsummen HCRC, FCRC die dynamischen Stuff-Bits mit einzuberechnen. Auch auf diese Weise sind die Fehler der Klassen 3 und 4 ausreichend sicher detektierbar. Der Grund hierfür ist, dass dynamische Stuff-Bits nur vom SOF-Bit bis vor dem FDF-Bit auftreten können. In diesem kleinen Bereich können maximal drei dynamische Stuff-Bits enthalten sein. Folglich ist der Burstfehler (Bündelfehler), der eine blockweise Störung des Bitstroms ist, und den ein Fehler der Klasse 3 erzeugen kann, in der Länge limitiert. Folglich ist die Wahrscheinlichkeit hoch, dass die Header CRC diesen Burstfehler detektieren kann. Die Detektion kann bei Verwendung von Fehlerrahmen 47 mit einem Fehlerrahmen 47 gemeldet werden.

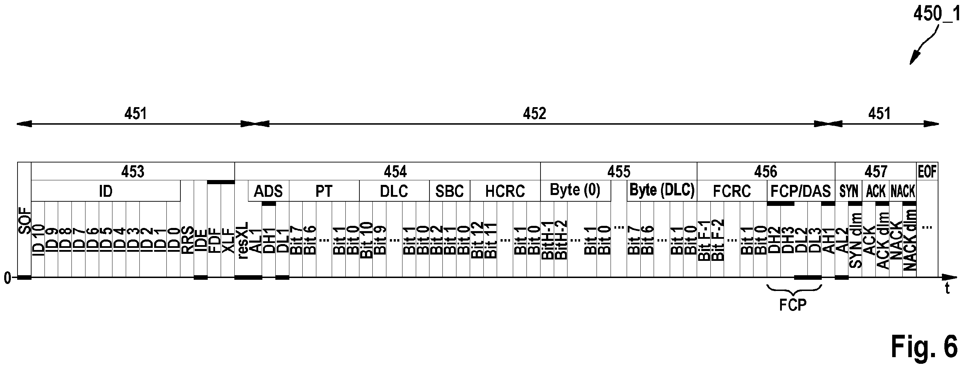

Fig. 6 zeigt einen Rahmen 450_1 gemäß einem zweiten Ausführungsbeispiel, bei welchem CAN XL und CAN FD kompatibel sind. Bei diesem Ausführungsbeispiel werden Fehlerrahmen (Error Flags) 47 verwendet, um Fehler zu signalisieren.

Bei dem vorliegenden Ausführungsbeispiel unterscheidet sich der Rahmen 450_1 und damit das CAN XL Rahmenformat von dem Rahmen 450 von Fig. 2, wie nachfolgend beschrieben. Hierbei sind nachfolgend nur die Unterschiede zu dem Rahmen 450 von Fig. 2 beschrieben. Im Übrigen sind die Rahmen 450, 450_1 der beiden Ausführungsbeispiele gleich.

In dem Rahmen 450_1 ist anstatt dem RP-Feld ein SYN-Feld mit konstanter Länge von 2 Bit vorhanden. Das SYN-Feld enthält ein erstes Bit (AL2) mit dem digitalen Wert 0. Zusammen mit dem vorhergehenden Bit (AH1) mit dem digitalen Wert 1 stellt die Bitfolge der Bits AL2, AH1 eine Synchronisationsflanke nach der Umschaltung der Bitrate sowie des Physical Layers (also des Modus des CAN XL Transceivers) bereit.

Somit sind zwei Synchronisationsflanken vorhanden, die man für eine robuste Funktion von CAN XL benötigt, nämlich eine Synchronisationsflanke unmittelbar vor der Bitratenumschaltung (DH3 => DL2) und eine Synchronisationsflanke unmittelbar nach der Bitratenumschaltung (AH1 => AL2). Dadurch kann sicher vor der Datenphase 452 in die Arbitrationsphase 451 geschaltet werden.

Das zweite Bit im SYN Feld, das SYNdlm Bit, hat den Wert 1. Es dient zur Abgrenzung zum ACK Bit. Das ACK Bit wird im fehlerfreien Fall von den Empfangsknoten als 0 (dominant) gesendet und erzeugt somit eine weitere Synchronisationsflanke.

Da Fehlerrahmen (Error Flags) 47 verwendet werden, ist die Nutzung eines NACK Feldes rein optional, da Fehler bereits mit Fehlerrahmen (Error Flags) 47 signalisiert werden können.

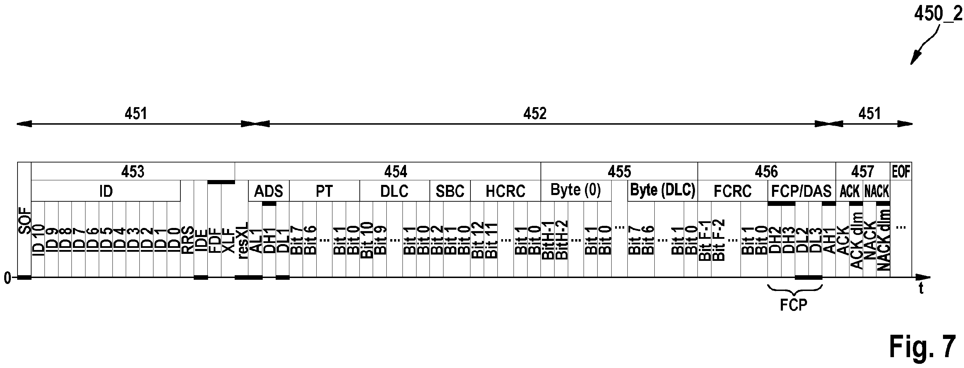

Fig. 7 zeigt einen Rahmen 450_2 gemäß einem dritten Ausführungsbeispiel, bei welchem CAN XL und CAN FD kompatibel sind. Bei diesem Ausführungsbeispiel werden Fehlerrahmen (Error Flags) 47 verwendet, um Fehler zu signalisieren.

Bei dem vorliegenden Ausführungsbeispiel unterscheidet sich der Rahmen 450_2 und damit das CAN XL Rahmenformat von dem Rahmen 450_1 von Fig. 6, wie nachfolgend beschrieben. Hierbei sind nachfolgend nur die Unterschiede zu dem Rahmen 450_1 von Fig. 6 beschrieben. Im Übrigen sind die Rahmen 450_1, 450_2 der beiden Ausführungsbeispiele gleich.

In dem Rahmen 450_2 ist weder ein RP-Feld noch ein SYN-Feld vorhanden. Daher erfolgt die notwendige Synchronisation nach der Bitratenumschaltung an der Flanke AH1 (1) => ACK (0). Diese Lösung hat zwei Vorteile.

Der erste Vorteil ist, dass der Phasenfehler bei dem Rahmen 450_2 von Fig. 7 kurz vor der Synchronisation auf die Flanke AH1 (1) => ACK (0) kleiner oder gleich dem Phasenfehler ist, der bei dem Rahmen 450_1 von Fig. 6 kurz vor der Synchronisation auf die Flanke SYNdlm (1) => ACK (0) vorherrscht. Der Grund dafür ist, dass bei dem Rahmen 450_2 von Fig. 7 seit der letzten Synchronisation nur 2 kurze Bit (DL2, DL3) und ein langes Bit (AH1) verstrichen sind. Dagegen sind bei dem Rahmen 450_1 von Fig. 6 zwei lange Bits verstrichen (AL2, SYNdlm).

Der zweite Vorteil ist ein geringerer Overhead des Rahmens 450_2 von Fig. 7 im Vergleich zu dem Rahmen 450_1 von Fig. 6. Der Rahmen 450_2 von Fig. 7 hat zwei lange Bits weniger als der Rahmen 450_1 von Fig. 6. Dadurch ist der Overhead kleiner und somit die Nettodatenrate höher.

Da auch bei dem vorliegenden Ausführungsbeispiel Fehlerrahmen (Error Flags) 47 verwendet werden, ist die Nutzung eines NACK Feldes rein optional, da Fehler bereits mit Fehlerrahmen (Error Flags) 47 signalisiert werden können.

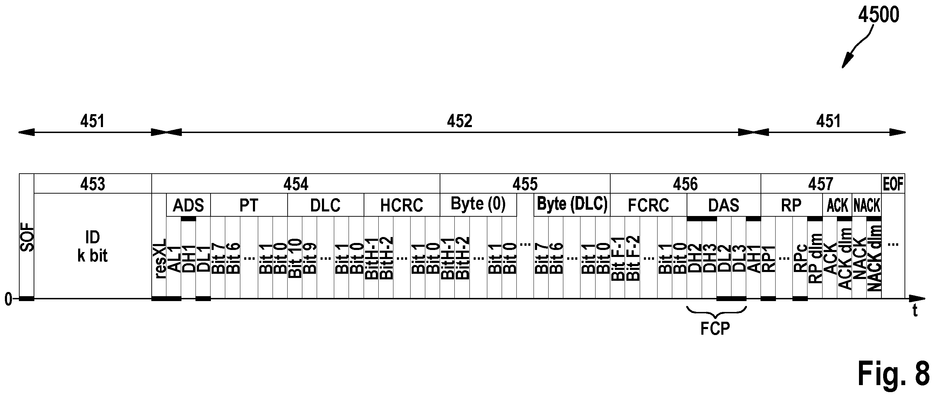

Fig. 8 zeigt einen Rahmen 4500 gemäß einem vierten Ausführungsbeispiel, bei welchem die Rahmen-Formate von CAN XL und CAN FD nicht kompatibel sind. Bei diesem Ausführungsbeispiel unterscheidet sich der Rahmen 4500 und damit das CAN XL Rahmenformat von dem Rahmen 450 von Fig. 2, wie nachfolgend beschrieben. Hierbei sind nur die Unterschiede zu dem Rahmen 450 von Fig. 2 beschrieben. Im Übrigen sind die Rahmen 450, 4500 der beiden Ausführungsbeispiele gleich.

Allgemein wird bei der Erzeugung des Rahmens 4500 gemäß dem vorliegenden Ausführungsbeispiel nur die feste Stuffing-Regel verwendet, so dass nach einer festen Zahl von Bits ein fixed Stuff-Bit einzufügen ist. Alternativ können statt nur einem Stuff-Bit auch zwei oder mehr Bits als fixed Stuff-Bits eingefügt werden. Dies führt bei bekanntem Wert des Datenlängecodes (DLC) zu einer konstanten Rahmenlänge bzw. einer konstanten Länge des Rahmens 4500. Dies verhindert verschiedene Probleme, die durch dynamische Stuff-Bits hervorgerufen werden. Folglich ist auch kein SBC-Feld im Kopf des Rahmens 4500 notwendig.

In dem Rahmen 4500 gemäß dem vorliegenden Ausführungsbeispiel ist der Identifizierer (ID) nicht mehr auf eine Anzahl von 11 Bits oder 29 Bits wie bei CAN FD beschränkt. Die Anzahl k der Bits des Identifizierers (ID) kann frei gewählt werden. Die Anzahl k ist jedoch alternativ auf einen festen Wert festlegbar. Für eine hohe Nettodatenrate ist eine ID mit k = 8 Bits sinnvoll. Diese reicht aus, um jeder Teilnehmerstation 10, 20, 30 des Bussystems 1 ausreichend viele Bus-Zugriffs-Prioritäten zu geben. Selbstverständlich ist jedoch ein anderer Wer für k wählbar, je nach Bedarf und Anzahl von verschiedenen Prioritäten in dem Bussystem 1.

Die Bits RRS, IDE, FDF, XLF des Rahmens 450 von Fig. 2 sind bei dem Rahmen 4500 nicht mehr notwendig und werden wegelassen. Dies spart 4 Bits ein, so dass der Rahmenüberhang reduziert wird. Dadurch wird die Nettodatenrate im Bussystem 1 erhöht.

Das Endefeld (EOF) hat in dem Rahmen 4500 nur noch eine Anzahl von fünf Bits, wenn das NACK-Bit dominant ist. Ist das NACK-Bit dagegen rezessiv, hat das Endefeld (EOF) eine Anzahl von drei Bits. Dies sorgt dafür, dass am Ende des Rahmens 4500 eine Anzahl von sechs rezessiven Bits gesendet wird. Diese Zahl von rezessiven Bits kann in einem gültigen Rahmen 4500 an keiner anderen Stelle vorkommen, wenn in der Arbitrationsphase 451 nach fünf gleichen Bits ein fixed Stuff-Bit eingefügt wird. Es könnten alternativ mehr als sechs Bits sein. Insbesondere muss die Zahl der EOF Bits an die Zahl der Bits, nach denen ein fixed Stuff-Bit eingefügt wird, angepasst werden.

Der Zwischenrahmenabstand (IFS) benötigt in dem Rahmen 4500 keine Mindestlänge. Insbesondere kann der Zwischenrahmenabstand (IFS) die Länge 0 haben. In einem solchen Fall werden zwei Rahmen 4500 nahtlos nacheinander gesendet. Jedoch ist ein Zwischenrahmenabstand (IFS) mit einer Anzahl von beispielsweise 1 Bit auch sinnvoll, um die Robustheit des Bussystems 1 im Vergleich zu dem zuvor genannten Fall zu erhöhen. Durch die nun sieben rezessiven Bits zwischen zwei Rahmen 4500 kann sich eine neue Teilnehmerstation am Bus 40 zuverlässiger synchronisieren.

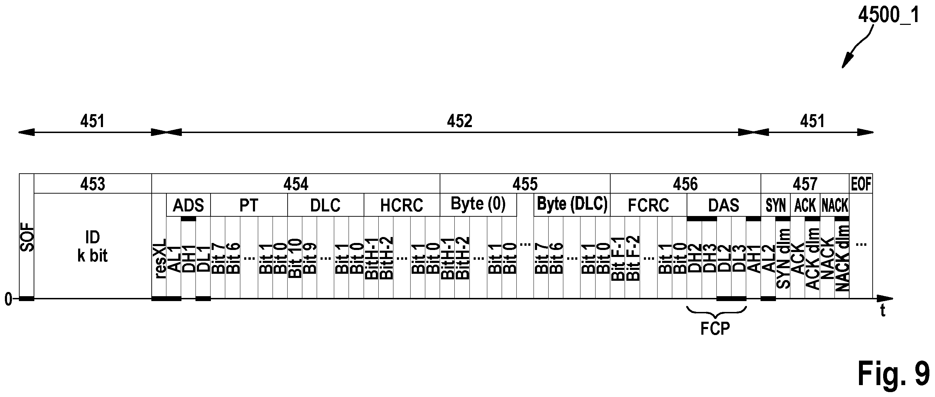

Fig. 9 zeigt einen Rahmen 4500_1 gemäß einem fünften Ausführungsbeispiel, bei welchem die Rahmen-Formate von CAN XL und CAN FD nicht kompatibel sind. Bei diesem Ausführungsbeispiel unterscheidet sich der Rahmen 4500_1 und damit das CAN XL Rahmenformat von dem Rahmen 4500 von Fig. 8, wie in Bezug auf das zweite Ausführungsbeispiel beschrieben.

Somit ist in dem Rahmen 4500_1 anstatt dem RP-Feld ein SYN-Feld mit konstanter Länge von 2 Bit vorhanden. Dadurch erfolgt die Synchronisation nach der Datenphase 452, wie in Bezug auf das zweite Ausführungsbeispiel beschrieben.

Im Übrigen sind die Rahmen 4500, 4500_1 der beiden Ausführungsbeispiele gleich.

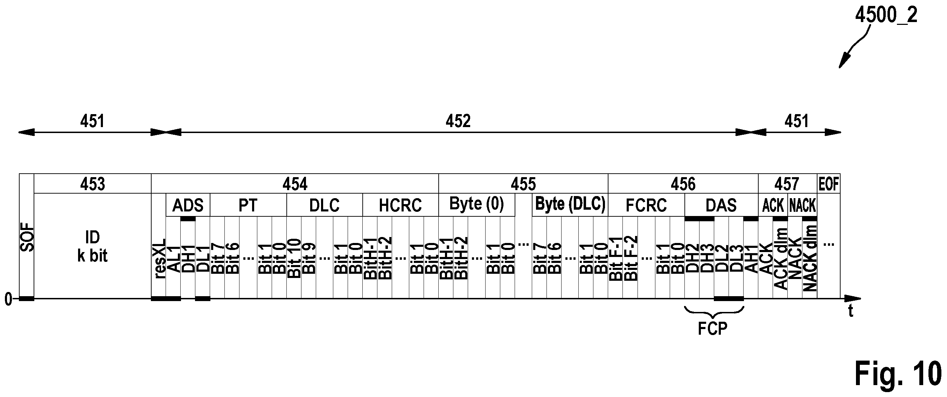

Fig. 10 zeigt einen Rahmen 4500_2 gemäß einem sechsten Ausführungsbeispiel, bei welchem die Rahmen-Formate von CAN XL und CAN FD nicht kompatibel sind. Bei diesem Ausführungsbeispiel unterscheidet sich der Rahmen 4500_2 und damit das CAN XL Rahmenformat von dem Rahmen 4500 von Fig. 8, wie in Bezug auf das dritte Ausführungsbeispiel beschrieben.

Somit ist in dem Rahmen 4500_2 weder ein RP-Feld noch ein SYN-Feld vorhanden. Dadurch erfolgt die Synchronisation nach der Datenphase 452, wie in Bezug auf das dritte Ausführungsbeispiel beschrieben.

Im Übrigen sind die Rahmen 4500, 4500_2 der beiden Ausführungsbeispiele gleich.

Alle zuvor beschriebenen Ausgestaltungen der Teilnehmerstationen 10, 20, 30, des Bussystems 1 und des darin ausgeführten Verfahrens können einzeln oder in allen möglichen Kombinationen Verwendung finden. Insbesondere können alle Merkmale der zuvor beschriebenen Ausführungsbeispiele und/oder deren Modifikationen beliebig kombiniert werden. Zusätzlich oder alternativ sind insbesondere folgende Modifikationen denkbar.

Auch wenn die Erfindung zuvor am Beispiel des CAN-Bussystems beschrieben ist, kann die Erfindung bei jedem Kommunikationsnetzwerk und/oder Kommunikationsverfahren eingesetzt werden, bei welchem zwei verschiedene Kommunikationsphasen verwendet werden, in denen sich die Buszustände unterscheiden, die für die unterschiedlichen Kommunikationsphasen erzeugt werden. Insbesondere ist die Erfindung bei Entwicklungen von sonstigen seriellen Kommunikationsnetzwerken, wie Ethernet und/oder 100 Base-T1 Ethernet, Feldbussystemen, usw. einsetzbar.

Insbesondere kann das Bussystem 1 gemäß den Ausführungsbeispielen ein Kommunikationsnetzwerk sein, bei welchem Daten seriell mit zwei verschiedenen Bitraten übertragbar sind. Es ist vorteilhaft, jedoch nicht zwangsläufige Voraussetzung, dass bei dem Bussystem 1 zumindest für bestimmte Zeitspannen ein exklusiver, kollisionsfreier Zugriff einer Teilnehmerstation 10, 20, 30 auf einen gemeinsamen Kanal gewährleistet ist.

Die Anzahl und Anordnung der Teilnehmerstationen 10, 20, 30 in dem Bussystem 1 der Ausführungsbeispiele ist beliebig. Insbesondere kann die

Teilnehmerstation 20 in dem Bussystem 1 entfallen. Es ist möglich, dass eine oder mehrere der Teilnehmerstationen 10 oder 30 in dem Bussystem 1 vorhanden sind. Denkbar ist, dass alle Teilnehmerstationen in dem Bussystem 1 gleich ausgestaltet sind, also nur Teilnehmerstation 10 oder nur Teilnehmerstation 30 vorhanden sind.

## Patentansprüche

1. Teilnehmerstation (10; 30) für ein serielles Bussystem (1), mit
einer Kommunikationssteuereinrichtung (11; 31) zum Steuern einer Kommunikation der Teilnehmerstation (10; 30) mit mindestens einer anderen Teilnehmerstation (10; 20; 30) des Bussystems (1), und
einer Sende-/Empfangseinrichtung (12; 32), die zum seriellen Senden eines von der Kommunikationssteuereinrichtung (11; 31) erzeugten Sendesignals (TXD) auf einen Bus (40) des Bussystems (1) ausgestaltet ist, und die zum seriellen Empfangen von Signalen von dem Bus (40) des Bussystems (1) ausgestaltet ist,
wobei die Kommunikationssteuereinrichtung (11; 31) ausgestaltet ist, das Sendesignal (TXD) gemäß einem Rahmen (450; 450_1; 450_2) zu erzeugen und in dem Rahmen (450; 450_1; 450_2) zwei Prüfsummen (HCRC, FCRC) einzufügen, die unterschiedliche Bits des Rahmens (450; 450_1; 450_2) einberechnen,
wobei die Kommunikationssteuereinrichtung (11; 31) ausgestaltet ist, in den Rahmen (450; 450_1; 450_2) dynamische Stuff-Bits derart einzufügen, dass nach 5 gleichen Bits in Folge ein inverses Stuff-Bit in den Bitstrom des Rahmens (450; 450_1; 450_2) eingefügt wird,
wobei die Kommunikationssteuereinrichtung (11; 31) ausgestaltet ist, ein erstes Feld (SBC) in den Rahmen (450; 450_1; 450_2) einzufügen, in dem die Anzahl der dynamischen Stuff-Bits codiert ist,
wobei die Kommunikationssteuereinrichtung (11; 31) ausgestaltet ist, ein zweites Feld (FCP) in den Rahmen (450; 450_1; 450_2; 4500; 4500_1; 4500_2) einzufügen, das zum Prüfen ausgestaltet ist, ob der Bitstrom des Rahmens (450; 450_1; 450_2; 4500; 4500_1; 4500_2) in einer Teilnehmerstation (10; 20; 30) des Bussystems (1), die den Rahmen (450; 450_1; 450_2; 4500; 4500_1; 4500_2) empfängt jedoch nicht gesendet hat, um mindestens ein Bit im Vergleich zu dem erwarteten Rahmen (450; 450_1; 450_2; 4500; 4500_1; 4500_2) versetzt ist,
wobei die Kommunikationssteuereinrichtung (11; 31) ausgestaltet ist, das mindestens eine erste Feld (SBC) vor einem Datenfeld (455) einzufügen, in dem Nutzdaten des Rahmens (450; 450_1; 450_2) eingefügt sind,
wobei die Kommunikationssteuereinrichtung (11; 31) ausgestaltet ist, das mindestens eine zweite Feld (FCP) nach dem Datenfeld (455) in dem Rahmen (450; 450_1; 450_2; 4500; 4500_1; 4500_2) einzufügen, und
wobei die Kommunikationssteuereinrichtung (11; 31) ausgestaltet ist, die zwei Prüfsummen (HCRC, FCRC) derart zu berechnen, dass maximal eine der zwei Prüfsummen (HCRC, FCRC) die dynamischen Stuff-Bits mit einberechnet.

2. Teilnehmerstation (10; 30) nach Anspruch 1, wobei die Kommunikationssteuereinrichtung (11; 31) ausgestaltet ist, als eine der zwei Prüfsummen (HCRC, FCRC) eine Kopfprüfsumme (HCRC) zur Absicherung eines Kopfes des Rahmens (450; 450_1; 450_2; 4500; 4500_1; 4500_2) zu berechnen und in die Kopfprüfsumme (HCRC) keine Bits einzuberechnen, die in dem Rahmenkopf immer einen festen Wert haben, sondern nur Bits des Rahmenkopfes einzuberechnen, die in dem Rahmenkopf einen von der Kommunikationssteuereinrichtung (11; 31) veränderbaren Wert haben.

3. Teilnehmerstation (10; 30) nach Anspruch 1 oder 2, wobei die Sende-/Empfangseinrichtung (12; 32) zum seriellen Senden eines von der Kommunikationssteuereinrichtung (11; 31) erzeugten Sendesignals (TXD) auf einen Bus (40) des Bussystems (1) derart ausgestaltet ist, dass sich für eine Nachricht (45), die zwischen Teilnehmerstationen (10, 20, 30) des Bussystems (1) ausgetauscht wird, die Bitzeit (t_bt) eines in einer ersten Kommunikationsphase (451) auf den Bus (40) gesendeten Signals unterscheiden kann von einer Bitzeit (t_bt) eines in einer zweiten Kommunikationsphase (452) gesendeten Signals.

4. Teilnehmerstation (10; 30) nach einem der vorangehenden Ansprüche, wobei die Kommunikationssteuereinrichtung (11; 31) ausgestaltet ist, das mindestens eine zweite Feld (FCP) nach dem Datenfeld (455) in dem Rahmen (450; 450_1; 450_2; 4500; 4500_1; 4500_2) und nach einer Rahmenprüfsumme (FCRC) einzufügen, die über alle Bits in dem Rahmen (450; 450_1; 450_2; 4500; 4500_1; 4500_2) gebildet wurde.

5. Teilnehmerstation (10; 30) nach Anspruch 4, wobei die Kommunikationssteuereinrichtung (11; 31) ausgestaltet ist, nach dem mindestens einen zweiten Feld (FCP) ein Synchronisationsfeld (SYN) mit zwei Bits in den Rahmen (450_1; 4500_1) derart einzufügen, dass die zwei Bits unterschiedliche Werte haben, so dass die Bits eine Synchronisationsflanke bilden, die nach einem Bitmuster zum Umschalten der Bitrate zum Senden des Sendesignals auf den Bus (40) und zum Umschalten eines Physical Layers der Sende-/Empfangseinrichtung (12; 32) angeordnet ist.

6. Teilnehmerstation (10; 30) nach einem der vorangehenden Ansprüche,
wobei der für die Nachricht (45) gebildete Rahmen (450; 450_1) kompatibel zu CAN FD aufgebaut ist, und
wobei in einer ersten Kommunikationsphase (451) ausgehandelt wird, welche der Teilnehmerstationen (10, 20, 30) des Bussystems (1) in einer nachfolgenden zweiten Kommunikationsphase (452) einen zumindest zeitweise exklusiven, kollisionsfreien Zugriff auf den Bus (40) bekommt.

7. Bussystem (1), mit
einem Bus (40), und
mindestens zwei Teilnehmerstationen (10; 20; 30), welche über den Bus (40) derart miteinander verbunden sind, dass sie seriell miteinander kommunizieren können und von denen mindestens eine Teilnehmerstation (10; 30) eine Teilnehmerstation (10; 30) nach einem der vorangehenden Ansprüche ist.

8. Verfahren zur Kommunikation in einem seriellen Bussystem (1), wobei das Verfahren mit einer Teilnehmerstation (10; 30) des Bussystems (1) ausgeführt wird, die eine Kommunikationssteuereinrichtung (11; 31) und eine Sende-/Empfangseinrichtung (12; 32) aufweist, wobei das Verfahren die Schritte aufweist,
Steuern, mit der Kommunikationssteuereinrichtung (11; 31) einer Kommunikation der Teilnehmerstation (10; 30) mit mindestens einer anderen Teilnehmerstation (10; 20; 30) des Bussystems (1), und
Senden, mit der Sende-/Empfangseinrichtung (12; 32), eines von der Kommunikationssteuereinrichtung (11; 31) erzeugten Sendesignals (TXD) auf einen Bus (40) des Bussystems (1), wobei die Sende-/Empfangseinrichtung (12; 32) zudem zum seriellen Empfangen von Signalen von dem Bus (40) des Bussystems (1) ausgestaltet ist,
Erzeugen, mit der Kommunikationssteuereinrichtung (11; 31), des Sendesignals (TXD) gemäß einem Rahmen (450; 450_1; 450_2)
wobei die Kommunikationssteuereinrichtung (11; 31) in den Rahmen (450; 450_1; 450_2) zwei Prüfsummen (HCRC, FCRC) einfügt, die unterschiedliche Bits des Rahmens (450; 450_1; 450_2) einberechnen,
wobei die Kommunikationssteuereinrichtung (11; 31) in den Rahmen (450; 450_1; 450_2) dynamische Stuff-Bits derart einfügt, dass nach 5 gleichen Bits in Folge ein inverses Stuff-Bit in den Bitstrom des Rahmens (450; 450_1; 450_2) eingefügt wird,
wobei die Kommunikationssteuereinrichtung (11; 31) ein erstes Feld (SBC) in den Rahmen (450; 450_1; 450_2) einfügt, in dem die Anzahl der dynamischen Stuff-Bits codiert ist,
wobei die Kommunikationssteuereinrichtung (11; 31) ein zweites Feld (FCP) in den Rahmen (450; 450_1; 450_2; 4500; 4500_1; 4500_2) einfügt, das zum Prüfen ausgestaltet ist, ob der Bitstrom des Rahmens (450; 450_1; 450_2; 4500; 4500_1; 4500_2) in einer Teilnehmerstation (10; 20; 30) des Bussystems (1), die den Rahmen (450; 450_1; 450_2; 4500; 4500_1; 4500_2) empfängt jedoch nicht gesendet hat, um mindestens ein Bit im Vergleich zu dem erwarteten Rahmen (450; 450_1; 450_2; 4500; 4500_1; 4500_2) versetzt ist,
wobei die Kommunikationssteuereinrichtung (11; 31) das mindestens eine erste Feld (SBC) vor einem Datenfeld (455) einfügt, in dem Nutzdaten des Rahmens (450; 450_1; 450_2) eingefügt sind,
wobei die Kommunikationssteuereinrichtung (11; 31) das mindestens eine zweite Feld (FCP) nach dem Datenfeld (455) in dem Rahmen (450; 450_1; 450_2; 4500; 4500_1; 4500_2) einfügt, und
wobei die Kommunikationssteuereinrichtung (11; 31) die zwei Prüfsummen (HCRC, FCRC) derart berechnet, dass maximal eine der zwei Prüfsummen (HCRC, FCRC) die dynamischen Stuff-Bits mit einberechnet.

## Claims

1. Node station (10; 30) for a serial bus system (1), having
a communication control device (11; 31) to control communication between the node station (10; 30) and at least one other node station (10; 20; 30) of the bus system (1), and
a transceiver device (12; 32) which is designed to serially transmit a transmit signal (TXD) generated by the communication control device (11; 31) onto a bus (40) of the bus system (1) and to serially receive signals from the bus (40) of the bus system (1),
wherein the communication control device (11; 31) is designed to generate the transmit signal (TXD) according to a frame (450; 450_1; 450_2) and to insert, into the frame (450; 450_1; 450_2), two checksums (HCRC, FCRC) which include different bits of the frame (450; 450_1; 450_2) in the calculation,
wherein the communication control device (11; 31) is designed to insert dynamic stuff bits into the frame (450; 450_1; 450_2) in such a manner that an inverse stuff bit is inserted into the bit stream of the frame (450; 450_1; 450_2) after 5 identical bits in succession, wherein the communication control device (11; 31) is designed to insert a first field (SBC) into the frame (450; 450_1; 450_2) in which the number of dynamic stuff bits is coded,
wherein the communication control device (11; 31) is designed to insert a second field (FCP) into the frame (450; 450_1; 450_2; 4500; 4500_1; 4500_2), which second field is designed to check whether the bit stream of the frame (450; 450_1; 450_2; 4500; 4500_1; 4500_2) is offset by at least one bit in comparison with the expected frame (450; 450_1; 450_2; 4500; 4500_1; 4500_2) in a node station (10; 20; 30) of the bus system (1) that receives but has not yet transmitted the frame (450; 450_1; 450_2; 4500; 4500_1; 4500_2),
wherein the communication control device (11; 31) is designed to insert the at least one first field (SBC) in front of a data field (455) in which payload data of the frame (450; 450_1; 450_2) are inserted,
wherein the communication control device (11; 31) is designed to insert the at least one second field (FCP) into the frame (450; 450_1; 450_2; 4500; 4500_1; 4500_2) after the data field (455), and
wherein the communication control device (11; 31) is designed to calculate the two checksums (HCRC, FCRC) in such a way that at most one of the two checksums (HCRC, FCRC) includes the dynamic stuff bits in the calculation.

2. Node station (10; 30) according to Claim 1, wherein the communication control device (11; 31) is designed to calculate, as one of the two checksums (HCRC, FCRC), a header checksum (HCRC) for protecting a header of the frame (450; 450_1; 450_2; 4500; 4500_1; 4500_2) and to not include in the calculation of the checksum header (HCRC) any bits which always have a fixed value in the frame header, but rather to include in the calculation only bits of the frame header which have a value that can be changed by the communication control device (11; 31) in the frame header.

3. Node station (10; 30) according Claim 1 or 2, wherein the transceiver device (12; 32) for serially transmitting a transmit signal (TXD) generated by the communication control device (11; 31) onto a bus (40) of the bus system (1) is designed in such a manner that, for a message (45) which is exchanged between node stations (10, 20, 30) of the bus system (1), the bit time (t_bt) of a signal transmitted onto the bus (40) in a first communication phase (451) can differ from a bit time (t_bt) of a signal transmitted in a second communication phase (452).

4. Node station (10; 30) according to one of the preceding claims, wherein the communication control device (11; 31) is designed to insert the at least one second field (FCP) into the frame (450; 450_1; 450_2; 4500; 4500_1; 4500_2) after the data field (455) and after a frame checksum (FCRC) that was formed over all bits in the frame (450; 450_1; 450_2; 4500; 4500_1; 4500_2).

5. Node station (10; 30) according to Claim 4, wherein the communication control device (11; 31) is designed to insert a synchronization field (SYN) containing two bits into the frame (450_1; 4500_1) after the at least one second field (FCP) in such a way that the two bits have different values, as a result of which the bits form a synchronization edge which is arranged according to a bit pattern for switching over the bit rate for transmitting the transmit signal onto the bus (40) and for switching over a physical layer of the transceiver device (12; 32).

6. Node station (10; 30) according to one of the preceding claims,
wherein the frame (450; 450_1) formed for the message (45) is designed to be compatible with CAN FD, and
wherein negotiation takes place in a first communication phase (451) in order to determine which of the node stations (10, 20, 30) of the bus system (1) is granted at least temporarily exclusive, collision-free access to the bus (40) in a subsequent, second communication phase (452) .

7. Bus system (1) having
a bus (40), and
at least two node stations (10; 20; 30) which are interconnected via the bus (40) in such a way that they can communicate serially with one another, and of which at least one node station (10; 30) is a node station (10; 30) according to one of the preceding claims.

8. Method for communicating in a serial bus system (1), wherein the method is carried out with a node station (10; 30) of the bus system (1) which has a communication control device (11; 31) and a transceiver device (12; 32), wherein the method has the following steps:
controlling, with the communication control device (11; 31), communication between the node station (10; 30) and at least one other node station (10; 20; 30) of the bus system (1), and
transmitting, with the transceiver device (12; 32), a transmit signal (TXD) generated by the communication control device (11; 31) onto a bus (40) of the bus system (1), wherein the transceiver device (12; 32) is also designed to serially receive signals from the bus (40) of the bus system (1),
generating, with the communication control device (11; 31), the transmit signal (TXD) according to a frame (450; 450_1; 450_2),
wherein the communication control device (11; 31) inserts, into the frame (450; 450_1; 450_2), two checksums (HCRC, FCRC) which include different bits of the frame (450; 450_1; 450_2) in the calculation,
wherein the communication control device (11; 31) inserts dynamic stuff bits into the frame (450; 450_1; 450_2) in such a manner that an inverse stuff bit is inserted into the bit stream of the frame (450; 450_1; 450_2) after 5 identical bits in succession,
wherein the communication control device (11; 31) inserts a first field (SBC) into the frame (450; 450_1; 450_2) in which the number of dynamic stuff bits is coded,
wherein the communication control device (11; 31) inserts a second field (FCP) into the frame (450; 450_1; 450_2; 4500; 4500_1; 4500_2), which second field is designed to check whether the bit stream of the frame (450; 450_1; 450_2; 4500; 4500_1; 4500_2) is offset by at least one bit in comparison with the expected frame (450; 450_1; 450_2; 4500; 4500_1; 4500_2) in a node station (10; 20; 30) of the bus system (1) that receives but has not transmitted the frame (450; 450_1; 450_2; 4500; 4500_1; 4500_2),
wherein the communication control device (11; 31) inserts the at least one first field (SBC) in front of a data field (455) in which payload data of the frame (450; 450_1; 450_2) are inserted,
wherein the communication control device (11; 31) inserts the at least one second field (FCP) into the frame (450; 450_1; 450_2; 4500; 4500_1; 4500_2) after the data field (455), and
wherein the communication control device (11; 31) calculates the two checksums (HCRC, FCRC) in such a way that at most one of the two checksums (HCRC, FCRC) includes the dynamic stuff bits in the calculation.

## Revendications

1. Station d'abonné (10 ; 30) pour un système de bus série (1), comprenant
un dispositif de commande de communication (11 ; 31) pour commander une communication de la station d'abonné (10 ; 30) avec au moins une autre station d'abonné (10 ; 20 ; 30) du système de bus (1), et
un dispositif émetteur/récepteur (12 ; 32) qui est configuré pour l'émission série d'un signal d'émission (TXD), généré par le dispositif de commande de communication (11 ; 31), sur un bus (40) du système de bus (1), et qui est configuré pour la réception série de signaux provenant du bus (40) du système de bus (1),
dans laquelle le dispositif de commande de communication (11 ; 31) est configuré pour générer le signal d'émission (TXD) selon une trame (450 ; 450_1 ; 450_2) et pour insérer dans la trame (450 ; 450_1 ; 450_2) deux sommes de contrôle (HCRC, FCRC) qui tiennent compte de différents bits de la trame (450 ; 450_1 ; 450_2),
dans laquelle le dispositif de commande de communication (11 ; 31) est configuré pour insérer dans la trame (450 ; 450_1 ; 450_2) des bits de bourrage dynamiques de telle sorte qu'un bit de bourrage inverse est inséré dans le train binaire de la trame (450 ; 450_1 ; 450_2) après 5 bits identiques d'affilée,
dans laquelle le dispositif de commande de communication (11 ; 31) est configuré pour insérer dans la trame (450 ; 450_1 ; 450_2) un premier champ (SBC) dans lequel est codé le nombre des bits de bourrage dynamiques,
dans laquelle le dispositif de commande de communication (11 ; 31) est configuré pour insérer dans la trame (450 ; 450_1 ; 450_2 ; 4500 ; 4500_1 ; 4500_2) un deuxième champ (FCP) qui est configuré pour vérifier si le train binaire de la trame (450 ; 450_1 ; 450_2 ; 4500 ; 4500_1 ; 4500_2) dans une station d'abonné (10 ; 20 ; 30) du système de bus (1) qui reçoit la trame (450 ; 450_1 ; 450_2 ; 4500 ; 4500_1 ; 4500_2) mais ne l'a pas émise est décalé d'au moins un bit en comparaison avec la trame attendue (450 ; 450_1 ; 450_2 ; 4500 ; 4500_1 ; 4500_2),
dans laquelle le dispositif de commande de communication (11; 31) est configuré pour insérer ledit au moins un premier champ (SBC) avant un champ de données (455) dans lequel sont insérées des données utiles de la trame (450 ; 450_1 ; 450_2),
dans laquelle le dispositif de commande de communication (11 ; 31) est configuré pour insérer dans la trame (450 ; 450_1 ; 450_2 ; 4500 ; 4500_1 ; 4500_2) au moins un deuxième champ (FCP) après le champ de données (455), et
dans laquelle le dispositif de commande de communication (11 ; 31) est configuré pour calculer les deux sommes de contrôle (HCRC, FCRC) de telle sorte qu'au maximum l'une des deux sommes de contrôle (HCRC, FCRC) tient également compte des bits de bourrage dynamiques.

2. Station d'abonné (10 ; 30) selon la revendication 1, dans laquelle le dispositif de commande de communication (11; 31) est configuré pour calculer comme l'une des deux sommes de contrôle (HCRC, FCRC) une somme de contrôle d'en-tête (HCRC) pour sécuriser un en-tête de la trame (450 ; 450_1 ; 450_2 ; 4500 ; 4500_1 ; 4500_2) et pour ne pas tenir compte dans la somme de contrôle d'en-tête (HCRC) de bits présentant toujours une valeur fixe dans l'en-tête de trame mais pour ne tenir compte que de bits de l'en-tête présentant une valeur pouvant être modifiée par le dispositif de commande de communication (11 ; 31).

3. Station d'abonné (10 ; 30) selon la revendication 1 ou 2, dans laquelle le dispositif émetteur/récepteur (12 ; 32) est configuré pour l'émission série d'un signal d'émission (TXD), généré par le dispositif de commande de communication (11 ; 31), sur un bus (40) du système de bus (1) de telle sorte que pour un message (45) qui est échangé entre des stations d'abonné (10, 20, 30) du système de bus (1), le temps bit (t_bt) d'un signal émis dans une première phase de communication (451) sur le bus (40) peut être différent d'un temps bit (t_bt) d'un signal émis dans une deuxième phase de communication (452).

4. Station d'abonné (10 ; 30) selon l'une quelconque des revendications précédentes, dans laquelle le dispositif de commande de communication (11 ; 31) est configuré pour insérer ledit au moins un deuxième champ (FCP) après le champ de données (455) dans la trame (450 ; 450_1 ; 450_2 ; 4500 ; 4500_1 ; 4500_2) et après une somme de contrôle de trame (FCRC) qui a été formée pour tous les bits dans la trame (450 ; 450_1 ; 450_2 ; 4500 ; 4500_1 ; 4500_2).

5. Station d'abonné (10 ; 30) selon la revendication 4, dans laquelle le dispositif de commande de communication (11 ; 31) est configuré pour insérer dans la trame (450_1 ; 4500_1), après ledit au moins un deuxième champ (FCP), un champ de synchronisation (SYN) de deux bits de telle sorte que les deux bits présentent des valeurs différentes de sorte que les bits forment un front de synchronisation qui est disposé après une configuration binaire pour commuter le débit binaire afin d'émettre le signal d'émission sur le bus (40) et de commuter une couche physique du dispositif émetteur/récepteur (12 ; 32).

6. Station d'abonné (10 ; 30) selon l'une quelconque des revendications précédentes,
dans laquelle la trame (450 ; 450_1) formée pour le message (45) est structurée de manière compatible avec CAN FD, et
dans laquelle on négocie dans une première phase de communication (451) laquelle des stations d'abonné (10, 20, 30) du système de bus (1) obtient dans une deuxième phase de communication (452) consécutive un accès au bus (40) sans collision, au moins temporairement exclusif.

7. Système de bus (1), comprenant
un bus (40), et
au moins deux stations d'abonné (10 ; 20 ; 30) qui sont reliées ensemble par le bus (40) de façon à pouvoir communiquer ensemble en série, et dont au moins une station d'abonné (10 ; 30) est une station d'abonné (10 ; 30) selon l'une quelconque des revendications précédentes.

8. Procédé de communication dans un système de bus série (1), dans lequel le procédé est exécuté par une station d'abonné (10 ; 30) du système de bus (1) qui présente un dispositif de commande de communication (11 ; 31) et un dispositif émetteur/récepteur (12 ; 32), le procédé présentant les étapes consistant à
commander, par le dispositif de commande de communication (11; 31), une communication de la station d'abonné (10 ; 30) avec au moins une autre station d'abonné (10 ; 20 ; 30) du système de bus (1), et
émettre, par le dispositif émetteur/récepteur (12 ; 32), un signal d'émission (TXD), généré par le dispositif de commande de communication (11 ; 31), sur un bus (40) du système de bus (1), dans lequel le dispositif émetteur/récepteur (12 ; 32) est en outre configuré pour la réception série de signaux provenant du bus (40) du système de bus (1),
générer, par le dispositif de commande de communication (11; 31), le signal d'émission (TXD) selon une trame (450 ; 450_1 ; 450_2),
dans lequel le dispositif de commande de communication (11 ; 31) insère dans la trame (450 ; 450_1 ; 450_2) deux sommes de contrôle (HCRC, FCRC) qui tiennent compte de différents bits de la trame (450 ; 450_1 ; 450_2),
dans lequel le dispositif de commande de communication (11 ; 31) insère dans la trame (450 ; 450_1 ; 450_2) des bits de bourrage dynamiques de telle sorte qu'un bit de bourrage inverse est inséré dans le train binaire de la trame (450 ; 450_1 ; 450_2) après 5 bits identiques d'affilée,
dans lequel le dispositif de commande de communication (11 ; 31) insère dans la trame (450 ; 450_1 ; 450_2) un premier champ (SBC) dans lequel est codé le nombre des bits de bourrage dynamiques,
dans lequel le dispositif de commande de communication (11 ; 31) insère dans la trame (450 ; 450_1 ; 450_2 ; 4500 ; 4500_1 ; 4500_2) un deuxième champ (FCP) qui est configuré pour vérifier si le train binaire de la trame (450 ; 450_1 ; 450_2 ; 4500 ; 4500_1 ; 4500_2) reçoit dans une station d'abonné (10 ; 20 ; 30) du système de bus (1) qui reçoit la trame (450 ; 450_1 ; 450_2 ; 4500 ; 4500_1 ; 4500_2) mais ne l'a pas émise est décalé d'au moins un bit en comparaison avec la trame attendue (450 ; 450_1 ; 450_2 ; 4500 ; 4500_1 ; 4500_2),
dans lequel le dispositif de commande de communication (11; 31) insère ledit au moins un premier champ (SBC) avant un champ de données (455) dans lequel sont insérées des données utiles de la trame (450 ; 450_1 ; 450_2),
dans lequel le dispositif de commande de communication (11; 31) insère ledit au moins un deuxième champ (FCP) après le champ de données (455) dans la trame (450 ; 450_1 ; 450_2 ; 4500 ; 4500_1 ; 4500_2), et
dans lequel le dispositif de commande de communication (11; 31) calcule les deux sommes de contrôle (HCRC, FCRC) de telle sorte qu'au maximum l'une des deux sommes de contrôle (HCRC, FCRC) tient également compte des bits de bourrage dynamiques.
